# EUROPÄISCHE PATENTSCHRIFT

(11) **EP 2 553 692 B1**
(45) Veröffentlichungstag und Bekanntmachung des Hinweises auf die Patenterteilung: **16.03.2016**
(21) Anmeldenummer: 11728174.1
(22) Anmeldetag: 16.03.2011
(51) Int. Cl.: H01F 1/34, H01F 1/40, H01F 10/193, H01F 10/20, C30B 23/02, C30B 25/02, C30B 29/22, C30B 33/04, G11C 11/14, H01L 21/316, C30B 29/64, G02F 1/00, G02F 1/05, G02F 1/355, G11C 11/22

(54) **DOMÄNENSTRUKTURIERTES FERROISCHES ELEMENT, VERFAHREN UND VORRICHTUNG ZUR ERZEUGUNG UND ZUR STEUERUNG DER ELEKTRISCHEN LEITFÄHIGKEIT VON DOMÄNENWÄNDEN BEI RAUMTEMPERATUR IN DEN ELEMENTEN SOWIE ANWENDUNGEN DES ELEMENTES**
DOMAIN STRUCTURED FERROIC ELEMENT, METHOD AND APPARATUS FOR GENERATION AND CONTROLING OF ELECTRIC CONDUCTIVITY OF DOMAIN WALLS AT ROOM TEMPERATURE IN THE ELEMENTS AND AS WELL APPLICATIONS OF THE ELEMENT
ELEMENT FERROIC STRUCTURE EN DOMAINE, METHODE ET APPAREIL POUR GENERATION ET CONTROLE DE LA CONDUCTIVITE ELECTIQUE DES PAROIS DE DOMAINE A TEMPERATURE AMBIENTE DANS LES ELEMENTS AINSI QUE DES APPLICATIONS DE L'ELEMENT

(30) Priorität: 01.04.2010 DE 102010014390
(43) Veröffentlichungstag der Anmeldung: 06.02.2013
(73) Patentinhaber: Technische Universität Dresden, 01069 Dresden (DE)
(72) Erfinder: ENG, Lucas, M., 01277 Dresden (DE); HAUSSMANN, Alexander, 01307 Dresden (DE); SCHROEDER, Mathias, 06686 Luetzen (DE)
(74) Vertreter: Hempel, Hartmut
(86) Internationale Anmeldenummer: PCT/DE2011/000294
(87) Internationale Veröffentlichungsnummer: WO 2011/120495

(56) Entgegenhaltungen:
- US-A- 5 800 767
- J. SEIDEL ET AL: "Conduction at domain walls in oxide multiferroics", NATURE MATERIALS, Bd. 8, Nr. 3, 1. März 2009 (2009-03-01), Seiten 229-234, XP55003042, ISSN: 1476-1122, DOI: 10.1038/nmat2373 in der Anmeldung erwähnt
- R. V. GAINUTDINOV ET AL: "Criterion for identification of ferroelectric domains in TGS crystals from AFM images", CRYSTALLOGRAPHY REPORTS, Bd. 52, Nr. 2, 1. März 2007 (2007-03-01), Seiten 332-337, XP55003040, ISSN: 1063-7745, DOI: 10.1134/S1063774507020289

## Beschreibung

Die Erfindung betrifft ein domänenstrukturiertes Element, eine Vorrichtung und ein Verfahren zur Erzeugung und zur Steuerung der elektrischen Leitfähigkeit von Domänenwänden bei Raumtemperatur in den Elementen sowie Anwendungen, basierend auf den domänenstrukturierten Elementen.

Ferroelektrische und ferroische Substanzen haben permanente elektrische Dipolmomente als remanente Polarisation, wobei die Orientierung des Dipolmoments durch äußere elektrische Felder oberhalb der sogenannten Koerzitivfeldstärke zwischen mehreren, nach Entfernung des äußeren Feldes für sich stabilen Zuständen durch Schalten bzw. Polen verändert werden kann. Insbesondere in einem zyklischen externen elektrischen Feld durchläuft die Polarisation eine Hystereseschleife. Das Umpolen geschieht dabei nicht gleichmäßig oder schlagartig, sondern es bilden sich nano-, später mikroskalige Bereiche - ferroelektrische/ferroischer Domänen - heraus, innerhalb derer die Umpolung schon vollzogen ist. Die Bildung weiterer Domänen oder das Wachstum bereits vorhandener Domänen vollzieht sich bei steigender externer elektrischer Feldstärke solange, bis der vollständig umgepolte eindomänige Zustand erreicht ist. Durch Entfernen des elektrischen Feldes während eines Zwischenzustands der Polung wird das vorhandene Domänenmuster fixiert. Ferroelektrische Einkristalle mit periodischem Domänenmuster finden breite Anwendung als nichtlinearoptische Bauelemente zur optischen Frequenzmischung oder auch in Speichern, dementsprechend weit entwickelt ist der Stand der Technik zur Erzeugung ferroelektrischer/ferroischer Domänenmuster. Ferroelektrika/Ferroika sind im Allgemeinen gute Isolatoren. Hinzugekommen ist allerdings, dass eine Domänenwand selbst eine Funktion und Funktionalität haben kann. Dies ist hier mit der Leitfähigkeit der Domänenwand der Fall.

Es sind Verfahren zur Erzeugung von Domänenwänden in der Druckschrift Müller M., Wechselwirkung von Licht mit ferroelektrischen Domänen in Lithiumniobat- und Lithiumtantalat-Kristallen, Dissertation, Bonn, 6/2004 beschrieben, wobei strukturierte flächige Elektroden, unterhalb derer das Koerzitivfeld überschritten wird, vorgesehen sind.

Ein weiteres Verfahren ist in dem Artikel Eng, L. M. Nanoscale domain engineering and characterization of ferroelectric domains, Nanotechnology, 10, 1999, S. 405-411 beschrieben, wobei eine Rasterkraftmikroskop(AFM)-Spitze auf ein vorgegebenes Potential gegenüber der Bodenelektrode gebracht wird, so dass lokal "unter" der Spitze das Koerzitivfeld überschritten wird.

Eine Möglichkeit des ionischen Transports, d.h. eine ionische Leitfähigkeit, oder auch des Einfangens von Ionen oder kristallographischen Fehlstellen entlang der Domänenwände in WO₃, CaTiO₃ und ähnlichen Materialien wird in den Druckschriften Salje, E.K.H. et al.: Ionic Transport in Twin Domain Walls, Ferroelectrics, 303, 2004, S. 3-7 und Salje, E.K.H. et al.: Enhanced reactivity of domain walls in WO3 with sodium, Eur. Phys., J. B 15, 2000, S. 205-210, sowie Salje, E.K.H. et al.: Trapping of oxygen vacancies on twin walls of CaTiO3: A computer simulation study, J. Phys., Condensed Matter 15, 2003, S. 2301-2307 beschrieben. Diese Materialien sind allerdings keine Ferroelektrika/Ferroika, so dass eine elegante Strukturierungsmöglichkeit mittels externer elektrischer Felder, wie bei Ferroelektrika/Ferroika möglich, hier nicht gegeben ist. Ebenso werden keine Verfahren zur Beeinflussung der Leitfähigkeitseigenschaften genannt. Es handelt sich auch nicht um Effekte, die bei Raumtemperatur aktiv sind.

Ein theoretisches Modell, welches das Umschaltverhalten in piezoelektrischen Keramiken angibt, ist in der Druckschrift Th. Steinkopff: Finite-element Modelling of Ferroic Domain Switching in Piezoelectic Ceramics, J. of the Europ. Ceramic Soc. 19, 1999, S. 1247-1249 beschrieben. Für die Simulation wird die Finite-Elemente-Methode genutzt. Die Materialien sind ferroelastisch, ferroelektrisch und piezoelektrisch. Des Weiteren sind sie polykristallin. Darin wird der Schaltvorgang der Domänen in polykristallinen Materialien untersucht. Die Domänenwand wird nicht gezielt geschrieben und auch nicht funktionalisiert.

Ein steuerbares optisches oder photonisches Element (z.B. opt. Wellenleiter, opt. Schalter, Resonatoren, photonische Kristalle, ...) ist in der Druckschrift US 2008/0019648 A1 beschrieben, das mit Licht manipuliert und gesteuert werden kann. Die Elemente bestehen aus ferroelektrischen oder anderen aktiven Materialien, welche je nach Anwendung strukturiert sind. Ziel ist es, die optischen Eigenschaften durch mechanische, elektrische, optische und thermische Einflüsse zu steuern.

Die Wellenleiteranwendung wird dabei durch gezieltes Strukturieren des Materials sowie des Domänenmusters erreicht. Aufgrund des unterschiedlichen Brechungsindex der einzelnen Domänen ist es möglich, das Licht im Material zu steuern. Die Eigenschaften der Domänenwand werden nicht genutzt. Es werden kein gezieltes Schreiben und keine Funktionalisierung der Domänenwand angegeben. Die optischen Eigenschaften können nur einmalig eingestellt werden und sind dann fix. Durch Wahl der richtigen Parameter können aber verschiedene Elemente mit verschiedenen Eigenschaften realisiert werden.

Ein Speicherelement in ferroelektrischen Dünnfilmen ist in der Druckschrift US 2009/0213492 A1 beschrieben. Dabei wird über ein spezielles Schaltverfahren die Stabilität der Domänen erhöht. Die Domänen werden mit einer Rasterkraftmikroskop-Spitze eingeschrieben. Jede Domäne entspricht dann einer Speichereinheit (Bit). Die Domänen können mit einer Vielzahl von Elektroden geschrieben werden. Die Rasterkraftmikroskop-Spitze eignet sich besonders, um kleine, nanoskalige Domänen zu schreiben. Im Wesentlichen ist die Stabilisierung von Domänenmustern angegeben. In Einkristallen sind die Domänen meist stabil und müssen nicht fixiert werden.

Es handelt sich um Dünnfilme und keine Einkristalle. Das Schalten von Domänen kann durch viele Methoden realisiert werden. Die Stabilisierung ist nur bei sehr kleinen Domänen notwendig. Es erfolgt kein gezieltes Schreiben und keine Funktionalisierung der Domänenwand.

Ein Speicherelement, welches aus einem Ferroelektrikum besteht, ist in der Druckschrift US 2009/0168635 A1 beschrieben. Die Speicherfunktion wird mittels ferroelektischen Domänen und zusätzlichen gefangenen Oberflächenladungen realisiert. Die Stabilität der Domänen soll damit erhöht werden. Des Weiteren wird das Schalten der Domänen erleichtert. Die Stabilität der Domänen in den Einkristallen ist kein Problem. Sehr kleine Domänen könnten damit realisiert werden.

Ein Bezug zur elektrischen Leitfähigkeit von Domänenwänden in dünnen Filmschichten ist in der Druckschrift Seidel, J. et al.: Conduction at domain walls in oxide multiferroics, Nature Materials, 8, 2009, S. 229-234 beschrieben, wobei die Domänenwandleitfähigkeit bestimmter Domänenwandsorten in BiFeO₃-Dünnfilmen mit dem Rasterkraftmikroskop bei Raumtemperatur lokal aufgelöst untersucht worden ist. Zur Abgrenzung ist festzuhalten:
- In der Druckschrift werden Dünnfilmproben untersucht, deren Dicke etwa 100 nm beträgt. Bei den Dünnfilmen ist die Stöchiometrie nur über größere Bereiche gemittelt vorgegeben; lokale Phasenseparationen sind möglich und sehr wahrscheinlich, wodurch der Effekt einer Domänenwandleitfähigkeit vorgetäuscht werden kann.
- Der Dünnfilm liegt polykristallin vor und somit sind Korngrenzen vorhanden. Die Korngrenzen können durch die veränderte Oberflächenchemie an der Kornoberfläche einen Transport von Ionen oder Elektronen an der Grenze ermöglichen. Dieser Transportmechanismus ist gänzlich unterschiedlich gegenüber der hier zentralen Domänenwandleitfähigkeit. Ebenso ist es möglich, dass beim Einschreiben der Domänenstruktur mit einer AFM-Rastersondenspitze die Domänenwand an der Komgrenze festgehalten ("gepinnt") wird. Damit ist das Zusammentreffen von Domänenwand und lokaler Leitfähigkeit nicht überraschend. Der Nachteil liegt darin, dass dann keine Domänenwandleitfähigkeit an beliebigen Orten einstellbar ist, sondern nur dann, wenn Komgrenze und Domänenwand zusammenfallen. Zudem kann der Effekt nicht eindeutig der Domänenwand bzw. der Korngrenze zugeordnet werden.
- Die Leitfähigkeitssignale können bei einem Dünnfilm auch vorgetäuscht werden, wenn ein topografischer Defekt vorliegt oder die Messspitze bis zur gegenüberliegenden Bodenelektrode vordringt, oder ein Durchschlag durch eine dünne verbleibende Schicht entsteht.
- Ein Problem besteht auch darin, dass es in den Dünnfilmschichten bisher keine Steuerungsmöglichkeit der elektrischen Leitfähigkeit gibt.

Es wird eingeschätzt, dass eine Domänenwandleitfähigkeit in ferroelektrischen/ferroischen Einkristallen bei Raumtemperatur bisher weder theoretisch noch experimentell rapportiert wurde.

Der Erfindung liegt die Aufgabe zugrunde, ein domänenstrukturiertes ferroisches Element, ein Verfahren und eine Vorrichtung zur Erzeugung und zur Steuerung der elektrischen Leitfähigkeit von Domänenwänden bei Raumtemperatur in den Elementen sowie Anwendungen des Elementes anzugeben, die derart geeignet ausgebildet sind, dass Domänenstrukturen in nanoskaligen Längenbereichen mit einer gesteuerten Strukturgeometrie und mit Schaffung neuer Funktionalitäten für verschiedene zum Teil gänzlich neue Anwendungen, basierend auf der Steuerungsfähigkeit der Domänenwandleitfähigkeit, Aufwand verringernd geschaffen werden.

Die Aufgabe wird durch die Merkmale der Patentansprüche gelöst.
In dem domänenstrukturierten Element mit mindestens einer Domänenwand zwischen benachbarten Domänen, verbunden zumindest mit einer Strommesseinrichtung zur Messung von Strom in der Domänenwand, sind die Domänen und die zwischenliegende, zumindest nanoskalige Domänenwand einem isolierenden ferroelektrischen/ferroischen Einkristall zugeordnet,
wobei die Domänenwände des Einkristalls als jeweilige leitfähige Diskontinuität nur wenige Nanometer in der Breite messen und so geformt sind, dass sie nanoskopische, mikroskopische und/oder makroskopische Bereiche von Einkristallen verbinden, wobei die Domänenwände
- von einer oberen Seitenfläche zu einer unteren Seitenfläche in vertikaler Richtung durch den Einkristall hindurch oder
- von einem ersten Kontaktpunkt zu einem zweiten Kontaktpunkt in lateraler Richtung des Einkristalls oder
- in Kombination von Seitenflächen und Kontaktpunkten des vorgegebenen Einkristalls
verlaufen,
wobei die zwischenliegende Domänenwand unter speziellen Einflüssen in Form von mechanischen Zug- oder Druckspannungen, elektrischen, magnetischen oder optischen Feldern oder von Dotierungen eine messbar in Form des elektrischen Stromes höhere elektrische Leitfähigkeit als die umgebenden Domänen aufweist, wobei die Strommesseinrichtung über Domänenwandstirnseiten von sich gegenüberliegenden Seitenflächen des Einkristalls mit angebrachten Elektroden in Kontakt mit der Domänenwand ist,
wobei gemäß dem Kennzeichenteil des Patentanspruchs 1
zur Erreichung und zur Ermittlung der höheren elektrischen Leitfähigkeit in der Domänenwand eine gesteuerte Einwirkung von elektrischer, magnetischer und/oder elektromagnetischer Anregungsenergie und/oder mechanischer Zug- und Druckspannung zumindest auf die Domänenwand des Einkristalls vorgesehen ist, wobei die ermittelte elektrische Leitfähigkeit größer als die elektrische Leitfähigkeit der benachbarten Domänen ist, wobei die elektrische Leitfähigkeit der Domänenwand in Form von elektrischem Strom mit unterschiedlich gepolten Elektroden mittels der mit den Elektroden verbundenen Strommesseinrichtung zwischen entgegengesetzten randseitigen Stirnbereichen der Domänenwand messbar und steuerbar ist, wobei die Steuerung der elektrischen Leitfähigkeit durch eine Variation von elektrischer, magnetischer und/oder elektromagnetischer Anregungsenergie und/oder mechanischer Zug- oder Druckspannung auf die Domänenwand möglich ist.

Die Steuerung der elektrischen Leitfähigkeit durch eine Variation von elektrischer, magnetischer und/oder elektromagnetischer Anregungsenergie und/oder mechanischer Zug- und/oder Druckspannung auf die Domänenwand ist durch Beleuchtung des Einkristalls mit UV-Licht unterschiedlicher Intensitäten und Wellenlängen unterhalb der Bandlücke möglich, wobei durch Abschalten der Beleuchtung die elektrische Leitfähigkeit in der Domänenwand vollständig ausschaltbar ist.

Zur gesteuerten Einwirkung von elektrischer, magnetischer und/oder elektromagnetischer Anregungsenergie und/oder mechanischer Zug- und/oder Druckspannung auf die Domänenwand können dem Element verschiedene Baugruppen zur Aussendung oder Übertragung von elektrischer, magnetischer und/oder elektromagnetischer Anregungsenergie und/oder mechanischer Zug- und/oder Druckspannung zugeordnet sein.

Der isolierende Einkristall kann als Ferroikum (Ferroelektrikum, Ferromagnetikum oder Ferroelastikum) oder Multiferroikum ausgebildet sein.

Das Element kann in Form eines Einkristalls, welcher dotierbar ist, vorliegen.

Dabei kann der Einkristall eine Dicke von wenigen Nanometern bis in den Millimeter-Bereich aufweisen.

Die Dicke der Domänenwände kann zwischen den benachbarten Domänen im Ein-Nanometerbereich und in einem Bruchteil des Ein-Nanometerbereiches ausgebildet sein.

Der Einkristall kann als Templat zur gezielten nasschemischen Adsorbatabscheidung auf dem Einkristall an der Domänenwand, wobei Spezies in Lösemittel an der Domänenwand durch Reaktion mit bereitgestellten Ladungsträgern reduzieren oder oxidieren, vorgesehen sein.

Der Einkristall kann auch als Templat zur gezielten Gasphasen-Adsorbatabscheidung auf dem Einkristall an der Domänenwand, wobei Spezies in Gasphase an der Domänenwand durch Reaktion mit bereitgestellten Ladungsträgern reduzieren oder oxidieren, vorgesehen sein.

Der Einkristall kann des Weiteren mit der elektrisch leitfähigen Domänenwand zur Wellenleiteranwendung eine veränderte Dielektrizitätskonstante in der Domänenwand bei einer Stirnseiten-/seitlichen Einkopplung von einfallendem Licht besitzen.

Das Verfahren zur Erzeugung und zur Steuerung der elektrischen Leitfähigkeit von Domänenwänden in den vorgenannten Elementen, das bei Raumtemperatur und an Luft durchgeführt wird, wird
gemäß dem Kennzeichenteil des Patentanspruchs 9
mit folgenden Schritte durchgeführt:
- Anbringen von Elektroden an sich gegenüberliegende Seitenflächen des Einkristalls,
- Erzeugung mindestens einer Domänenwand im Einkristall zwischen zwei entstehenden Domänenstrukturen zumindest mittels eines angelegten elektrischen oder optischen Feldes,
- gesteuerte Zuführung von elektrischer, magnetischer und/oder elektromagnetischer Anregungsenergie und/oder mechanischem Stress zumindest unter Einbeziehung der Domänenwand,
- Messung der durch das elektrische Feld und der zugeführten elektrischen, magnetischen und/oder elektromagnetischen Anregungsenergie und/oder der mechanischen Zug- und/oder Druckspannung ausgelösten und steuerbaren elektrischen Leitfähigkeit der Domänenwand.

Die Domänenwände können jeweils als eine Schicht nanoskaliger Kontaktierung erstellt werden, wobei mit Hilfe der Domänenwände sowohl mit lonen- als auch mit Elektronen/Lochtransport der Einkristall kontaktiert und so Ströme geleitet werden, wodurch eine Integration und eine Adressierung des Einkristalls auf der Ein-Nanometer-Längenskala erreicht wird.

Eine Löschung der Leitfähigkeit der Domänenwände wird über das Löschen der gesamten Domänenstruktur durch komplettes Polen, wobei ein Einbringen in ein homogenes elektrisches Feld oberhalb einer vorgegebenen Koerzitivfeldstärke erfolgt, durchgeführt, wobei der Prozess mit einer Verschiebung der Domänenwände zur Vergrößerung des in dem homogenen elektrischen Feld ausgerichteten Domänenvolumenanteils geschieht und zur Veränderung der Domänenstruktur verwendet wird.

Zusätzlich zum Topografiebild im Kontaktmodus kann die lokale piezoelektrische Reaktion auf eine Wechselspannung an dem spitzwinkligen Endteil der Rastersondenspitze gemessen werden, aus der eine Domänenverteilung im Einkristall und damit die Lage der leitfähigen Domänenwände ermittelt werden kann.

Mindestens eine durch geometrische Parameter vorgegebene Domänenwand kann mittels einer Einrichtung zur Einschreibung, die sich im Bereich des Einkristalls befindet, in den Einkristall solange eingeschrieben werden, bis eine nanoskalige Domänenwand erreicht wird, die von einer Seitenfläche bis zur gegenüberliegenden Seitenfläche des Einkristalls kristalldurchgängig ausgebildet wird, wobei die eingeschriebenen Domänenwände entsprechend vorgegebener zeitlicher und örtlicher Parameter wahlweise löschbar und/oder innerhalb des Einkristalls verschiebbar gesteuert werden.

Die Lage der Domänenwände kann vorgegeben und eine Steuerung festgelegt werden, um die eingebrachten Domänenwände
- gesteuert zu einzuschreiben,
- gesteuert zu löschen und
- gesteuert zu verschieben.

Die Domänenwände können jeweils als eine Schicht mit einer Templatfunktion versehen werden, um organische, anorganische, biologische Moleküle, Atome, Salze an die Kontaktstellen zu adsorbieren, wobei sich dorthin aufgrund des hohen elektrischen Feldgradienten und der damit verbundenen Polarisation oder Polarisierbarkeit gezielt Strukturen adsorbieren und absorbieren lassen, wobei das Templat die Funktion erfüllt, großflächig und mit einer Genauigkeit von einem Nanometer oder Bruchteilen von einem Nanometer Strukturen aufzubauen.

Die Domänenwände können auch jeweils als eine Schicht mit einer Modulation der komplexen dielektrischen Konstanten ε erstellt und leitfähig ausgebildet werden, so dass sich ihre dielektrischen, resistiven und optischen Parameter ändern, wodurch der Einkristall in den Domänenwänden vom Isolator zum Leiter geschaltet wird und somit eine Modulation und Variation der Parameter auf der Ein-Nanometer-Längenskala eingestellt werden.

Einerseits kann in die Domänenwand Licht über die Frontseite in einen Eingang eingekoppelt werden und die Domänenwand kann als Wellenleiter dienen und/oder andererseits kann eine seitliche Einkopplung des Lichts über eine Seitenfläche für eine abgeschwächte Totalreflexion an der elektrisch leitfähigen Domänenwand durchgeführt werden.

In der Domänenwand kann ein Ionentransport herbeigeführt werden, wobei Dotierionen durch das angelegte elektrische Feld aus der benachbarten Domänenstruktur gezogen werden, so dass Ionen von den Kontaktpunkten oder von der Stirnfläche der Domänenwand aus passend nachgeschoben werden.

Zu einer Vorrichtung zur Steuerung der elektrischen Leitfähigkeit von Domänenwänden in den vorgenannten Elementen, kann
gemäß dem Kennzeichenteil des Patentanspruchs 19
eine an das Element über die Domänenwand durch stirnseitig gegenüberliegend kontaktierende Elektroden angeschlossene Strommesseinrichtung gehören, wobei die Vorrichtung
- eine Lichtquelle zur Beleuchtung zumindest der Domänenwand und/oder
- eine Spannungsquelle zur Erzeugung eines elektrischen Feldes zwischen den beiden Elektroden, wobei wahlweise eine Beleuchtung mit einstellbarer Wellenlänge und/oder einstellbarer Intensität des Lichtes und/oder eine variable Spannung zur Ausbildung einer variablen elektrischer Feldstärke vorhanden sind, und
- eine Steuereinheit, die mit der Strommesseinrichtung verbunden ist und die mit der Lichtquelle und/oder mit der Spannungsquelle in energieversorgungsleitungsmäßiger und signaltechnischer Verbindung steht,
enthalten kann.

Zu einer anderen Vorrichtung zur Steuerung der elektrischen Leitfähigkeit von Domänenwänden in den vorgenannten Elementen kann
gemäß dem Kennzeichenteil des Patentanspruchs 20
eine an das Element über die Domänenwand durch stirnseitig gegenüberliegend kontaktierende Elektroden angeschlossene Strommesseinrichtung gehören, wobei die Vorrichtung neben der Steuereinheit, die mit der Strommesseinrichtung verbunden ist, einen Magneten mit konstanter Feldstärke oder dimensioniert variabler magnetischer Feldstärke enthält, wobei das magnetische Feld die Domänenwand durchdringt, wobei der Magnet mit variabler Feldstärke mit der Steuereinheit in energieversorgungs- und signaltechnischer Verbindung steht.

Der Magnet kann in die Vorrichtung mit Beleuchtung und/oder variablem elektrischen Feld integriert sein, wobei die vorgesehenen Verbindungsleitungen zwischen den einzelnen Baugruppen weitgehend bestehen bleiben.

Zu einer weiteren Vorrichtung zur Steuerung der elektrischen Leitfähigkeit von Domänenwänden in den genannten Elementen kann
gemäß dem Kennzeichenteil des Patentanspruchs 22
eine an das Element über die Domänenwand durch stirnseitig gegenüberliegend kontaktierende Elektroden angeschlossene Strommesseinrichtung gehören, wobei die Vorrichtung neben der Steuereinheit, die mit der Strommesseinrichtung verbunden ist, einen Kondensator mit konstanter Feldstärke oder dimensioniert variabler elektrischer Feldstärke enthält, wobei das elektrische Feld die Domänenwand durchdringt, wobei der Kondensator mit variabler Feldstärke mit der Steuereinheit in energieversorgungs- und signaltechnischer Verbindung steht.

Der Kondensator kann in die Vorrichtung mit Beleuchtung und/oder variablem elektrischen Feld integriert sein, wobei die vorgesehenen Verbindungsleitungen zwischen den einzelnen Baugruppen weitgehend bestehen bleiben.

Zu einer weiteren Vorrichtung zur Steuerung der elektrischen Leitfähigkeit von Domänenwänden in den genannten Elementen kann
gemäß dem Kennzeichenteil des Patentanspruchs 24
eine an das Element über die Domänenwand durch stirnseitig gegenüberliegend kontaktierende Elektroden angeschlossene Strommesseinrichtung gehören, wobei die Vorrichtung neben der Steuereinheit, die mit der Strommesseinrichtung verbunden ist, eine Anordnung zur Übertragung von Zug/Druckspannungen ,hier bezeichnet als "Biegestation", welche Zug- oder Druckspannungen auf das domänenstrukturierte Element und somit auf die Domänenwand ausübt, wobei die Biegestation mit der Steuereinheit in energieversorgungsleitungsmäßiger und signaltechnischer Verbindung steht, wobei die Zug- oder Druckspannung durch eine mechanische Verbiegung eines Substrates oder durch einen piezomechanischen Aktor einstellbar ist.

Die Biegestation kann in die Vorrichtung mit Beleuchtung und/oder variablem elektrischen Feld und/oder mit dem variablen magnetischen Feld integriert sein, wobei die vorgesehenen Verbindungsleitungen zwischen den einzelnen Baugruppen weitgehend bestehen bleiben.

Eine Einrichtung zur Erzeugung und zur Steuerung von elektrisch leitfähigen Domänenwänden in den genannten Elementen kann
gemäß dem Kennzeichenteil des Patentanspruchs 26
unter Verwendung eines im Element integrierten isolierenden ferroelektrischen/ferroischen Einkristalls enthalten
- zumindest eine Steuereinrichtung, die
- einen Speicher für die geometrischen und die strukturzugehörigen Parameter des Einkristalls und
- einen Speicher für die vorgegebenen geometrischen und strukturzugeordneten Parameter der einzuschreibenden Domänenwände aufweist, und
- zumindest ein Rechen- und Steuerwerk, mit dem die vorgegebenen Parameter berechnet und die Signale erzeugt werden, um die vorgegebenen Domänenwände in den Einkristall einzuschreiben und wahlweise die eingeschriebenen Domänenwände zu löschen oder innerhalb des Einkristalls in vorgegebene Lagen zu verschieben,
- mindestens einen Kopf mit mindestens zwei Elektroden mit den zugeordneten Kontakt/Abgriffselementen zum Einschreiben, Löschen und Verschieben der nanoskaligen Domänenwände,
- eine Positionierungs- und Halterungseinrichtung für den Einkristall sowie
- zumindest zugehörige energieversorgungs- und signaltechnische Verbindungsleitungen zwischen der Steuereinrichtung und zugeordneten Baugruppen.

Eine Verwendung von nanoskalige Domänenwände enthaltenden, vorgenannten Elementen unter Einsatz eines vorgenannten Verfahrens besteht
gemäß dem Kennzeichenteil des Patentanspruchs 27 darin,
dass der Einkristall mit mindestens einer Domänenwand als Wellenleiter durch eine veränderte Dielektrizitätskonstante ε in der elektrisch leitfähigen Domänenwand mit einer Stirnseiten-/seitlichen Einkopplung von Licht oder evaneszenten Einkopplung eingesetzt wird.
Die Domänenwände können jeweils als eine Schicht mit einer Modulation der komplexen dielektrischen Konstanten ε erstellt und leitfähig ausgebildet werden, so dass sich ihre dielektrischen, resistiven und optischen Parameter ändern, wodurch der Einkristall in den Domänenwänden vom Isolator zum Leiter geschaltet wird und somit eine Modulation und Variation der Parameter auf der Ein-Nanometer-Längenskala eingestellt werden kann.

Eine andere Verwendung von nanoskalige Domänenwände enthaltenden, genannten Elementen unter Einsatz eines vorgenannten Verfahrens besteht gemäß dem Kennzeichenteil des Patentanspruchs 28 darin,
dass als Einkristall mit den nanoskaligen Domänenwänden ein Templat zur gezielten, nasschemischen Adsorbatabscheidung von Adsorbatpartikeln angewendet wird, wobei die in einer flüssigen Lösung vorhandenen frei beweglichen gelösten Adsorbatpartikel sich an die Nanokontaktpunkte der Domänenwände anlagern.
Dabei können folgende Vorgänge stattfinden:
Die in der flüssigen Adsorbatlösung vorhandenen frei beweglichen gelösten Adsorbatpartikel können sich unter UV-Beleuchtung mit Photonenenergien oberhalb der Bandlücke sich an die Nanokontaktpunkte der Domänenwände anlagern. Die Adsorbatpartikel, welche sich in Lösung und/oder Gasphase befinden, können sich durch eine Redox-Reaktion an der Domänenwand anlagern und mit bereitgestellten Ladungsträgern reduzieren bzw. oxidieren (chemische Deposition) oder aber durch die elektrostatischen Streufelder infolge der in den Domänen verschieden ausgerichteten elektrischen Polarisation des Kristalls von den Domänenwänden angezogen werden und sich ebenfalls dort anlagern (elektrostatische Deposition).

Die Domänenwände können jeweils als eine Schicht mit einer Templatfunktion fungieren, um organische, anorganische, biologische Moleküle, Atome, Salze an die Kontaktstellen zu adsorbieren, wobei sich dorthin aufgrund des hohen elektrischen Feldgradienten und der damit verbundenen Polarisation oder Polarisierbarkeit gezielt Strukturen adsorbieren und absorbieren lassen, wobei das Templat die Funktion erfüllt, großflächig und mit einer Genauigkeit von einem Nanometer oder Bruchteilen von einem Nanometer Strukturen aufzubauen.

Der als Templat ausgebildete Einkristall kann zu einem Substrat transportiert und dort durch Anpressen die Adsorbatpartikel auf das Substrat aufgedruckt werden, wobei nach Lösen des Templats vom Substrat weg gerichtet die von den Adsorbatpartikeln übertragene Struktur als Druck an dem Substrat haften bleibt.

Weitere Vorteile der Erfindung sind, dass
- die mit dem Einkristall und den erfindungsgemäßen Vorrichtungen gemessenen Ströme deutlich höher sind als die in der Druckschrift Seidel,J. et al.: Conduction at domain walls in oxide multiferroics, Nature Materials, 8, 2009, S. 229-234 gemessenen Ströme (bis zu 100 pA in Spitzen im Vergleich zu 0,3 pA),
- es mit dem Einkristall möglich wird, die Ladungsträgerkonzentration an der Domänenwand für ein Aufbauverfahren von Nanostrukturen zu nutzen.
- Der Aufbau von Nanostrukturen auf den Einkristallen ist bei Raumtemperatur unter Umgebungsbedingungen möglich. Hierzu zählen die Integration von Atomen, Molekülen, Zellen, Nanopartikeln, Nanoröhren (kohlenstoffartig, siliziumartig), aber auch viele andere Materialien wie Organellen und ganze Organellen-Gebilde.

Die Erfindung nutzt im Gegensatz zum Stand der Technik die besonderen Eigenschaften der Domänenwände aus, welche bisher im technologischen Einsatz der Ferroelektrika/Ferroika keine Rolle gespielt haben. Die im Stand der Technik angegebenen Verfahren zur Domänenstrukturierung sind für die angegebenen Anwendungsfälle genauso verwendbar.

Weiterbildungen und weitere Ausgestaltungen der Erfindung werden in weiteren Unteransprüchen angegeben.

Die Erfindung wird anhand von Ausführungsbeispielen mittels mehrerer Zeichnungen näher erläutert.
Es zeigen:
- Fig. 1: eine schematische Darstellung eines domänenstrukturierten Elements mit einer ersten Vorrichtung zur Steuerung der messbaren elektrischen Leitfähigkeit,
- Fig. 2a: eine schematische Darstellung eines domänenstrukturierten Elements mit einer zweiten Vorrichtung zur Steuerung der messbaren elektrischen Leitfähigkeit,
- Fig. 2b: eine schematische Darstellung eines domänenstrukturierten Elements mit einer dritten Vorrichtung zur Steuerung der messbaren elektrischen Leitfähigkeit,
- Fig. 2c: eine schematische Darstellung eines domänenstrukturierten Elementes mit einer vierten Vorrichtung zur Steuerung der messbaren elektrischen Leitfähigkeit,
- Fig. 3: eine schematische Darstellung einer Einrichtung zur Einschreibung von nanoskaligen Domänenwänden in einem Einkristall, wobei mit der Einrichtung auch ein Löschen und ein Verschieben der eingeschriebenen Domänenwände durchgeführt werden kann, mit zugeordneten Teilfiguren Fig. 3a, Fig. 3b, Fig. 3c, die die Ausbildung und Verschiebung von Domänenwänden zeigen,
- Fig. 4: eine Darstellung des Terminals zur Kontaktierung des Einkristalls,
- Fig. 5: eine schematische Darstellung der optischen Funktionalität als Wellenleiter des Domänenwände enthaltenden Einkristalls durch räumliche Modulation,
- Fig. 6: eine schematische Darstellung eines Templats zur gezielten nasschemischen Adsorbatabscheidung, wobei Fig. 6a vor der Adsorbatpartikelabscheidung und Fig. 6b nach der Adsorbatpartikelabscheidung zeigen,
- Fig. 7: eine schematische Darstellung eines Druckvorgangs mit Adsorbatpartikel nach Fig. 6a und Fig. 6b, wobei
Fig. 7a ein mit Adsorbatpartikeln belegter Einkristall im Zustand des Anpressens und Druckens und
Fig. 7b ein Einkristall ohne Adsorbatpartikel im Zustand des Lösens
zeigen.

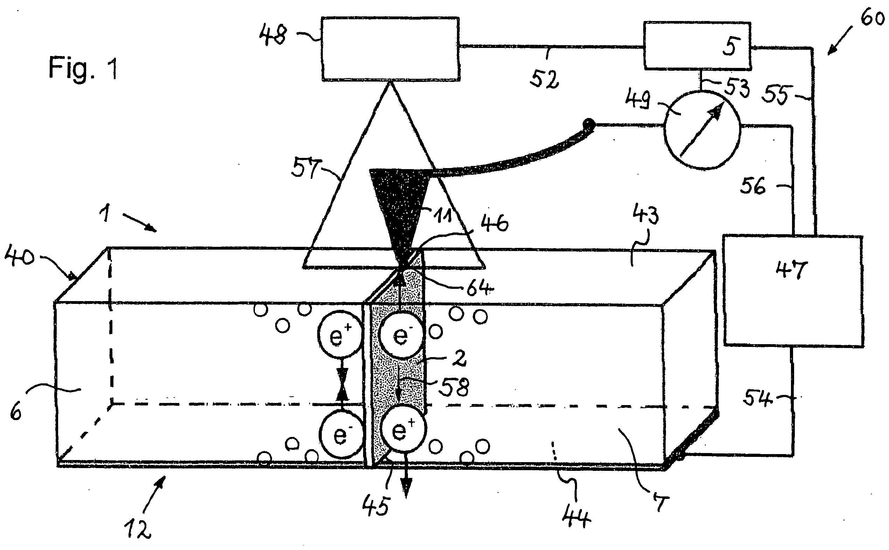

In Fig. 1 ist ein domänenstrukturiertes Element 1 mit mindestens einer Domänenwand 2 zwischen zwei Domänen 6, 7 dargestellt.

Die Domänen 6, 7 und die zwischenliegende, zumindest nanoskalige Domänenwand 2 sind einem isolierenden ferroelektrischen/ferroischen Einkristall 40 zugeordnet, wobei die zwischenliegende Domänenwand 2 eine messbar höhere elektrische Leitfähigkeit als die umgebenden Domänen 6, 7 unter speziellen Einflüssen aufweist, wobei die elektrische Leitfähigkeit der Domänenwand 2 zumindest mit einer Strommesseinrichtung 47, die über Domänenwandstirnseiten 45, 46 der sich gegenüberliegenden Seitenflächen 43, 44 des Einkristalls 40 mit angebrachten Elektroden 11, 12 in Kontakt mit der Domänenwand 2 ist, messbar ist.

Um erfindungsgemäß eine höhere elektrische Leitfähigkeit in der Domänenwand 2 zu erreichen und auch zu messen, kann unter speziellen Einflüssen (mechanische Zug/Druckspannungen (Stress), elektrische, magnetische und/oder optische Felder, Dotierung, etc.) eine gesteuerte Einstrahlung von elektrischer, magnetischer und/oder elektromagnetischer Anregungsenergie und/oder unter mechanischen Zug- oder Druckspannungen zumindest auf die Domänenwand 2 des Einkristalls 40 die höhere elektrische Leitfähigkeit der Domänenwand 2 ausbilden, die größer als die elektrische Leitfähigkeit der benachbarten Domänen 6, 7 ist, die ihre Isolationseigenschaft beibehalten, wobei die elektrische Leitfähigkeit in Form von elektrischem Strom mit unterschiedlich gepolten Elektroden 11, 12 mittels der mit den Elektroden 11, 12 verbundenen Strommesseinrichtung 47 zwischen entgegengesetzten randseitigen Stirnseiten 45, 46 der Domänenwand 2 messbar und steuerbar ist.

Die gesteuerte Einstrahlung von gesteuerter Zuführung von elektrischer, magnetischer und/oder elektromagnetischer Anregungsenergie und/oder mechanischen Zug- und Druckspannungen kann mit verschiedenen Baugruppen zur Aussendung oder Übertragung von elektrischer, magnetischer und/oder elektromagnetischer Anregungsenergie und/oder mechanischen Zug- und Druckspannungen durchgeführt werden. Diese Baugruppen werden im Folgenden angegeben.

Die Strommesseinrichtung 47 kann in Fig. 1 in einer ersten Vorrichtung 60 zur Steuerung der messbaren elektrischen Leitfähigkeit der Domänenwand 2 integriert sein, wobei die Vorrichtung 60 enthält
- eine Lichtquelle 48 zur Beleuchtung 57 zumindest der Domänenwand 2 und/oder
- eine Spannungsquelle 49 zur Erzeugung eines elektrischen Feldes 58 zwischen den beiden Elektroden 11, 12,
   wobei eine Beleuchtung mit einstellbarer Wellenlänge und einstellbarer Intensität des Lichtes 57 und/oder eine variable Spannung zur Ausbildung einer variablen elektrischer Feldstärke 58 vorhanden sind, und
- eine Steuereinheit 5, die mit der Strommesseinrichtung 47 verbunden ist und die wahlweise mit der Lichtquelle 48 und/oder mit der Spannungsquelle 49 in energieversorgungsleitungsmäßiger und signaltechnischer Verbindung steht.

Während die Elektrode 12 eine flächige, über die Seitenfläche 44 des Einkristalls 40 angebrachte Bodenelektrode sein kann, ist vorzugsweise die auf der anderen gegenüberliegenden Seitenfläche 43 angeordnete Elektrode 11 eine Rastersondenspitze (ein Cantilever mit einseitig angebrachter Spitze), deren spitzer Endteil 64 im nanoskaligen Dimensionierungsbereich liegt und auf der anderen Seitenfläche 43 den Einkristall 40 berührt und die meist bewegbar angeordnet ist. Die Elektrode 12 kann eine ebensolche Spitze aufweisen wie sie Elektrode 11 aufweist.

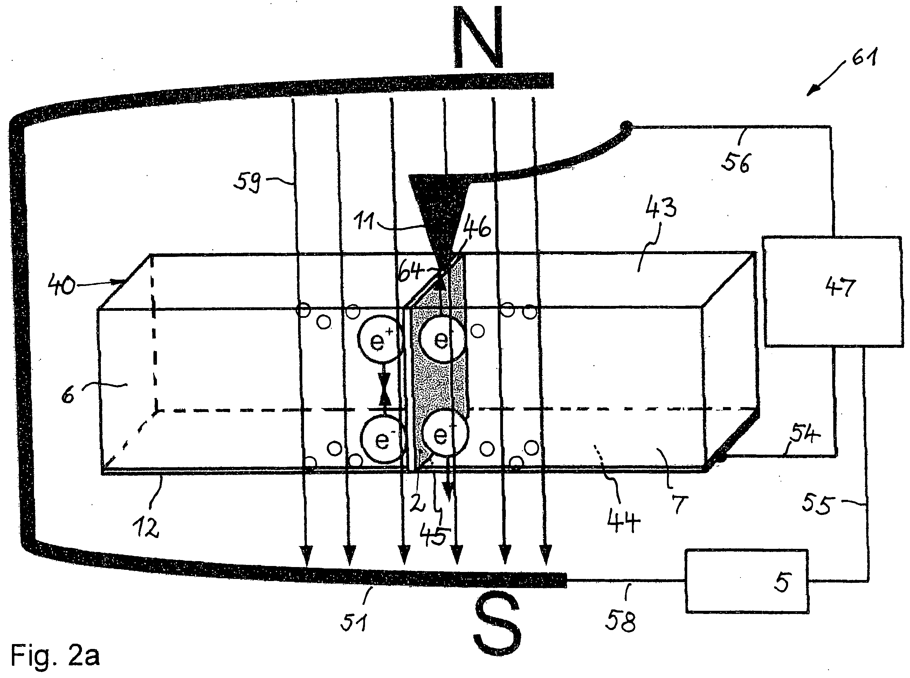

Die Strommesseinrichtung 47 kann in Fig. 2a in einer zweiten Vorrichtung 61 zur Steuerung der messbaren elektrischen Leitfähigkeit der Domänenwand 2 integriert sein, wobei die zweite Vorrichtung 61 enthält
- neben der Steuereinheit 5, die mit der Strommesseinrichtung 47 verbunden ist, und
- einen Magneten 51 mit konstanter Feldstärke oder dimensioniert variabler magnetischer Feldstärke 59, wobei der Magnet 51 mit variabler Feldstärke 59 mit der Steuereinheit 5 in energieversorgungsleitungsmäßiger und signaltechnischer Verbindung steht, wobei die Steuereinheit 5 mit der Strommesseinrichtung 47 insbesondere zum Abgriff der gemessenen Stromstärke in Verbindung steht,.

Der Magnet 51 kann auch in die erste Vorrichtung 60 integriert sein (nicht eingezeichnet), wobei die vorgesehenen Verbindungen/Verbindungsleitungen 52, 53, 54, 55, 56 zwischen den einzelnen Baugruppen 48, 49, 51, 47 weitgehend bestehen bleiben.

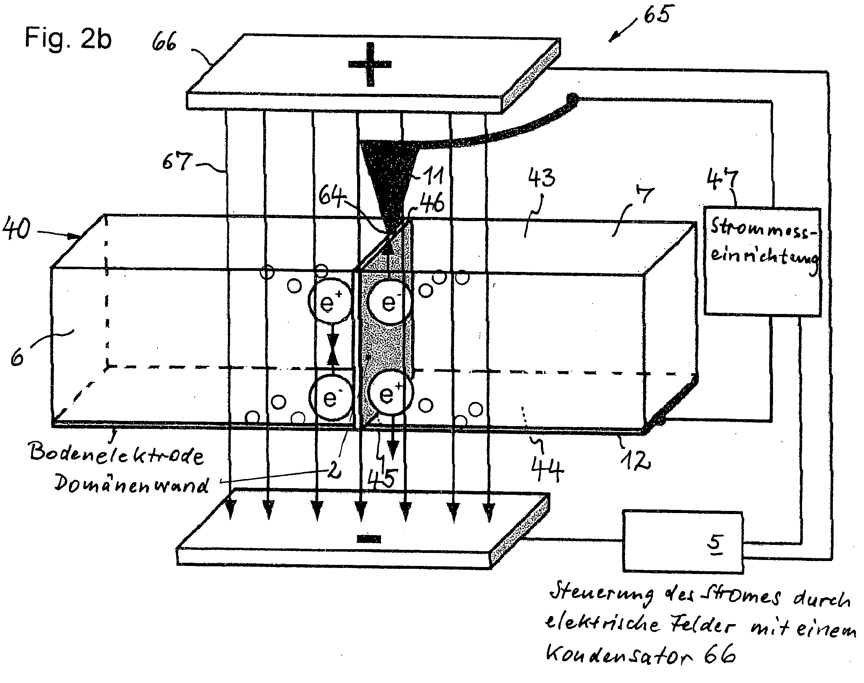

Die Strommesseinrichtung 47 kann in Fig. 2b in einer dritten Vorrichtung 65 zur Steuerung der messbaren elektrischen Leitfähigkeit der Domänenwand 2 integriert sein, wobei die dritte Vorrichtung 65 enthält
- neben der Steuereinheit 5, die mit der Strommesseinrichtung 47 verbunden ist, und
- einen Kondensator 66 mit konstanter elektrischer Feldstärke oder dimensioniert variabler elektrischer Feldstärke 67, wobei der Kondensator 66 mit variabler Feldstärke 67 mit der Steuereinheit 5 in energieversorgungsleitungsmäßiger und signaltechnischer Verbindung steht, wobei die Steuereinheit 5 mit der Strommesseinrichtung 47 in Verbindung stehen kann, insbesondere zum Abgriff der gemessenen Stromstärke.

Der Kondensator 66 kann auch in eine der ersten Vorrichtungen 60 integriert sein, wobei die vorgesehenen Verbindungen/Verbindungsleitungen 52, 53, 54, 55, 56 zwischen den einzelnen Baugruppen 48, 49, 51, 47 weitgehend bestehen bleiben.

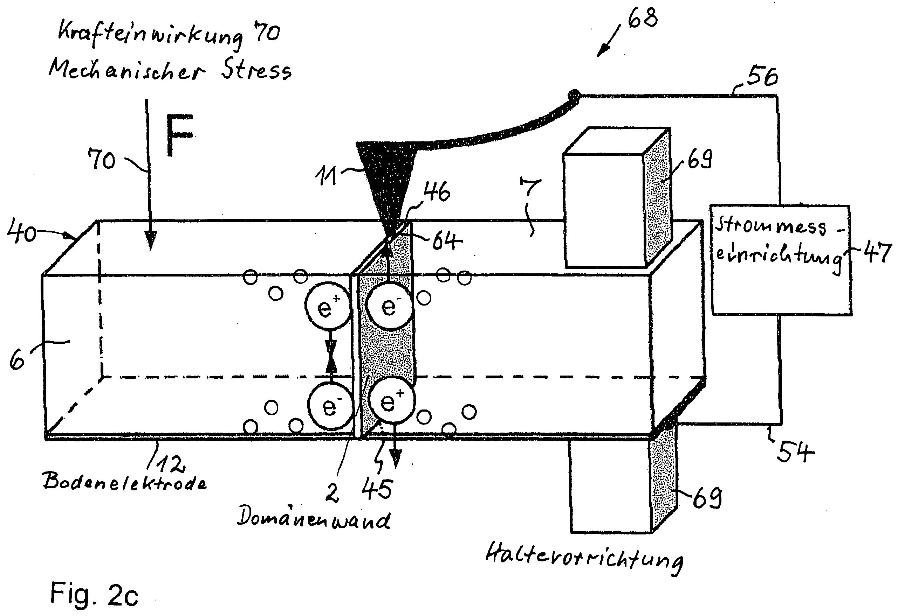

Die Strommesseinrichtung 47 kann in Fig. 2c in einer vierten Vorrichtung 68 zur Steuerung der messbaren elektrischen Leitfähigkeit der Domänenwand 2 integriert sein, wobei die vierte Vorrichtung 68 enthält
- neben der Steuereinheit 5, die mit der Strommesseinrichtung 47 verbunden ist, und
- eine Anordnung zur Übertragung mechanischer Zug/Druckspannungen - Biegestation - 69 auf mindestens eine Domäne 7 des Einkristalls 40 zum Anlegen von konstantem oder dimensioniert variablem mechanischen Stress 70 (Zug- und Druckspannungen), wobei die Biegestation 69 mit variablem mechanischem Stress 70 mit der Steuereinheit 5 in energieversorgungsleitungsmäßiger und signaltechnischer Verbindung steht, wobei die Steuereinheit 5 mit der Strommesseinrichtung 47 in Verbindung stehen kann, insbesondere zum Abgriff der gemessenen Stromstärke.

Die Biegestation 69 kann auch in eine der ersten Vorrichtungen 60 integriert sein, wobei die vorgesehenen Verbindungen/Verbindungsleitungen 52, 53, 54, 55, 56 zwischen den einzelnen Baugruppen 48, 49, 51, 47 weitgehend bestehen bleiben.

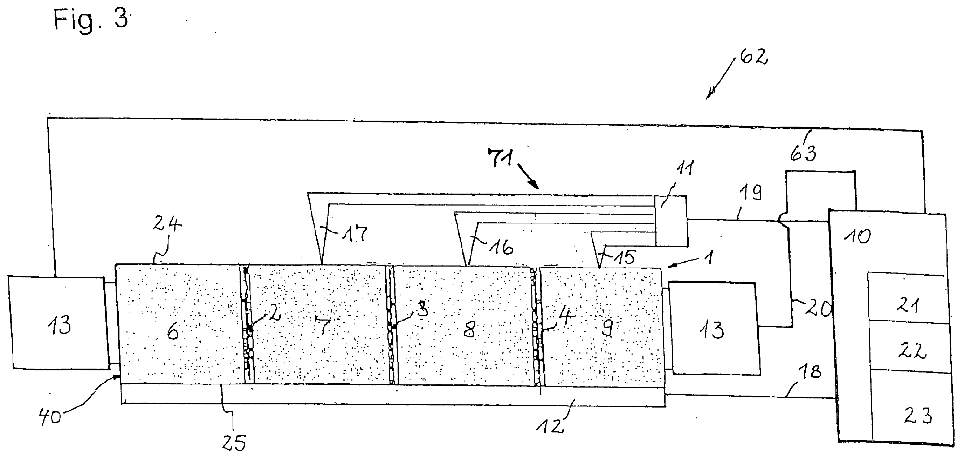

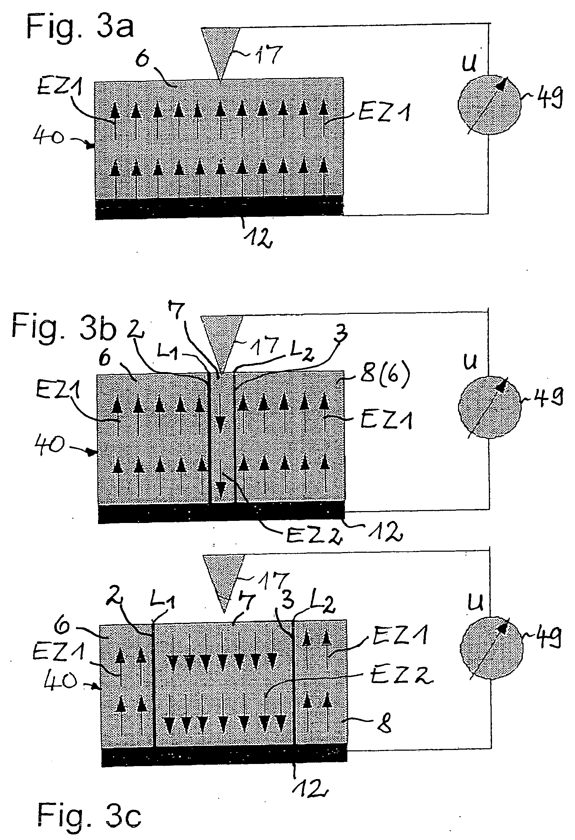

In Fig. 3 ist eine schematische Darstellung einer Einrichtung 62 zur Einschreibung und zur Steuerung von nanoskaligen Domänen und somit auch nanoskaligen Domänenwänden 2, 3, 4 in den ferroelektrischen/ferroischen isolierenden Einkristall 40 gezeigt, die enthält
- zumindest eine Steuereinrichtung 10, die
- einen Speicher 21 für die geometrischen und die strukturzugehörigen Parameter des Einkristalls 40 und
- einen Speicher 22 für die vorgegebenen geometrischen und strukturzugeordneten Parameter der einzuschreibenden Domänenwände 2, 3, 4 aufweist, und
- zumindest ein Rechen- und Steuerwerk 23, mit dem die vorgegebenen Parameter berechnet und die Signale erzeugt werden, um die vorgegebenen Domänen 6, 7, 8, 9 und somit die Domänenwände 2, 3, 4 in den Einkristall 40 einzuschreiben und wahlweise die eingeschriebenen Domänenwände 2, 3, 4 zu löschen oder innerhalb des Einkristalls 40 in vorgegebene Lagen zu verschieben,
- einen Kopf 71 mit der Elektrode 11 mit den zugeordneten spitzwinklig ausgebildeten Kontaktelementen (z.B. jeweils eine Spitze eines Rasterkraftmikroskops) 15, 16, 17 und der flächigen Bodenelektrode 12 zum Einschreiben, Löschen und Verschieben der nanoskaligen Domänen 6, 7, 8, 9 und Domänenwände 2, 3, 4,
- eine Positionierungs- und Halterungseinrichtung 13 für den Einkristall 40 sowie
- zumindest die zugehörigen energieversorgungsleitungstechnischer und signaltechnischen Verbindungsleitungen 18, 19, 20, 63 zwischen der Steuereinrichtung 10 und den übrigen zugeordneten Baugruppen 11, 13.

Die Ausbildung und die Verschiebung der Domänenwände 2 in dem domänenstrukturierten Einkristall 40 ist anhand eines Kontaktelementes 17 in Form einer AFM-Spitze und einer Bodenelektrode 12 in den der Fig. 3 zugeordneten Figuren 3a, 3b, 3c gezeigt.
Für die Fig. 3a, 3b und 3c gibt es folgende Funktionsdarstellungen:
Für die Fig. 3a ergibt sich bei einer angelegten Spannung U = 0 aus einer Spannungsquelle 49 somit auch ein elektrisches Feld mit einer Feldstärke E = 0.
Dabei bleiben alle Einheitszellen EZ1 des Einkristalls 40 gleich ausgerichtet mit einer in der Zeichnungsebene nach oben gerichteten Polarisation und der Einkristall 40 ist somit eindomänig.
Für die Fig. 3b ergibt sich ein erster Domänentyp 6, 8 mit den Einheitszellen EZ1 mit senkrecht nach oben gerichteter Polarisation und ein zweiter Domänentyp 7 mit einer Einheitszelle EZ2 mit senkrecht nach unten gerichteter Polarisation, wobei eine an mit der Spannungsquelle 49 verbundenen Elektroden 17, 12 angelegte Spannung U vorhanden ist, wobei die Spannung U mit U > U_{koerzitiv} größer als die Koerzitivspannung U_{koerzitiv} und somit ein elektrisches Feld E zwischen den Elektroden 17 und 12 mit einer Feldstärke E > E_{koerzitiv} größer als die Koerzitivfeldstärke E_{koerzitiv}, sind.
Bei einer Polung durch das elektrische Feld E unter der AFM-Spitze 17 kurz nach dem Einschalten polen sich die Einheitszellen EZ1 unter der Spitze 17 zu Einheitszellen EZ2 um, und es entsteht eine Polarisation nach unten gerichtet, so dass sich drei Domänen 6, 7, 8 mit zwei Domänenwänden 2, 3 ausbilden. Für die Fig. 3c ergibt sich bei einer angelegten Spannung U mit U > 0 mit der elektrischen Feldstärkebedingung E > E_{koerzitiv} bei längerer Zeitdauer t mit t» 0, dass sich mehr und mehr Einheitszellen EZ2 unter der Spitze 17 mit einer Polarisation nach unten gerichtet umpolen.
Schließlich werden drei Domänen 6, 7, 8 mit zwei Domänenwänden 2, 3 erhalten, wobei die mittlere Domäne 7 immer in die Breite größer wächst, wodurch sich die Lagen L₁, L₂ der Domänenwände 2, 3 ändern.
Die Domänenwände 2, 3 können nur über die Größe der Domäne 6, 7, 8 gesteuert werden. Es ist kein direktes Einschreiben möglich, da jeweils die Einheitszellen EZ1 in EZ2 umgepolt werden müssen.
Eine Domänenwand 2, 3 liegt immer zwischen entgegengesetzt polarisierten Einheitszellen EZ1 und EZ2.

Die Vorteile bestehen darin, dass eine Verbindung elektrischer, elektronischer, optischer, mechanischer, magnetischer und anderer Auswirkungen auf der Ein-Nanometer-Längenskala vorgesehen sein kann. Es ist möglich, die erfindungsgemäß ausgebildeten elektrisch leitfähigen Domänenwände 2, 3, 4 im Einkristall 40 als Wellenleiter, Kontakte, Templatfunktion, modulierte Dielektrizitätsstruktur zu benutzen. Damit ist eine großflächige, variable und versatile Integration von der makroskopischen Skala zur Nanometerskala möglich.

Die Kombination der Strommesseinrichtung 47 und der Spannungsquelle 49 mit einstellbarer Spannung U kann in Form eines Rasterkraftmikroskops mit einem angeschlossenen Leitfähigkeitsmodul ausgebildet sein, wobei die der elektrischen Leitfähigkeit proportionale messbare Stromstärke durch Variation der Beleuchtung 57 aus einer Lichtquelle 48 mit einstellbarer Intensität und/oder einstellbarer Wellenlänge und/oder durch Variation der angelegten Spannung U und/oder durch Variation des magnetischen Feldes 59 durch einen Magneten und/oder durch Variation des elektrischen Feldes 67 durch einen Kondensator steuerbar ist.

In dem Verfahren zur Einschreibung von nanoskaligen Domänenwänden 2, 3, 4 in den Einkristall 40 werden die durch geometrische Parameter vorgegebenen Domänenwände 2, 3, 4 mittels der in Fig. 3 gezeigten Einrichtung 62 zur Einschreibung, die sich im Bereich des Einkristalls 40 befindet und den Einkristall 40 umfasst, in den Einkristall 40 derart eingeschrieben, bis nanoskalige Domänenwände 2, 3, 4 erreicht werden, die von einer Seitenfläche 24 bis zur gegenüberliegenden Seitenfläche 25 des Einkristalls 40 kristalldurchgängig ausgebildet werden, wobei die eingeschriebenen Domänenwände 2, 3, 4 entsprechend vorgegebener zeitlicher und örtlicher Parameter wahlweise löschbar und/oder innerhalb des Einkristalls 40 durch Änderungen der Domänenstruktur verschiebbar gesteuert werden können.

Die Einkristalle 40 können ferroische (ferroelektrisch, ferromagentisch oder ferroelastisch) und multiferroische (Kombination mehrerer Eigenschaften) isolierende Einkristalle sein, wobei die Lage/der Ort und die Art der Domänenwand 2, 3, 4 über die Einrichtung 62 zur Einschreibung derart gewählt werden können, dass die Domänenwand 2, 3, 4 verschiedene Polarisationsrichtungen (Ordnungsparameter der dielektrischen, magnetischen, optischen Polarisation) trennt.

Die Domänenwände 2, 3, 4 sind in dieser Form als leitfähige Diskontinuitäten ausgebildet.

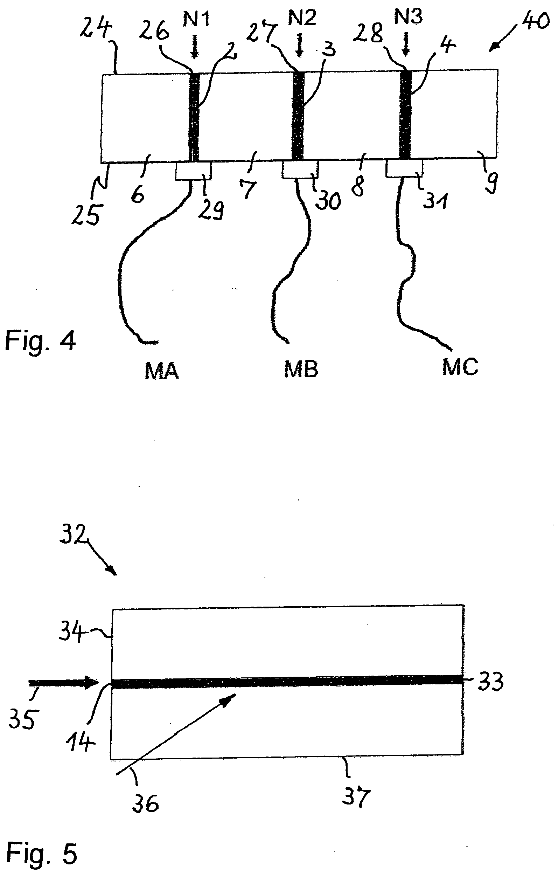

In Fig. 4 ist eine schematische Darstellung eines Einkristalls 40 in Form eines Terminals mit vier Domänen 6, 7, 8, 9, gezeigt. Die zwischen den vier nanoskaligen Domänen 6, 7, 8, 9 befindlichen Domänenwände 2, 3, 4 weisen auf der einen Seitenfläche 24 die drei Nanokontaktpunkte 26, 27, 28, an welche Nanostrukturen als funktionale Bauteile (z.B. Transistoren, ...) angelagert werden können und auf der anderen Seitenfläche 25 des Einkristalls 40 die Makrokontaktpunkte (z.B. durch eine flächige Elektrode) 29, 30, 31 auf.

Es ist ebenfalls möglich, parallel verschiedene Nano-Terminalkontaktpunkte 26, 27, 28 zeitgleich über die Steuereinrichtung 10 anzusteuern (N-Terminalkontakte). Damit sind eine Integration komplexer Nanostrukturen und der großflächige bottom-up Aufbau von Nanostrukturen auf makroskopischem Einkristall 40 mit nanoskaligen Domänenwänden 2, 3, 4 im Sinne der Nanotechnologie möglich.

Es ist des Weiteren, wie in Fig. 5 gezeigt ist, möglich, eine komplett isolierende Oberfläche durch leitfähige Diskontinuitäten (Pin-Points) zu durchdringen, um so Funktionalität in lateraler, aber auch vertikaler Richtung einzubringen. Hierbei kann sich der Leitfähigkeitsbereich der Domänenwand 33 zwischen einem isolierenden Kontakt der benachbarten Domänen und einem leitfähigen Kontakt der dazwischenliegenden Domänenwand 33 über mehrere Größenordnungen ändern.

Der Erfindung basiert darauf, dass mindestens eine Domänenwand 2, 3, 4, 33 in einem Einkristall 40 vorhanden ist bzw. erzeugt werden kann. Sowohl die Lagen L₁, L₂ usw. (in Fig. 3a, 3b, 3c) als auch die Art der Domänenwand 2, 3, 4, 33 können festgelegt werden, so dass die Domänenwande 2, 3, 4, 33 verschiedene Polarisationsrichtungen (Ordnungsparameter der dielektrischen, magnetischen, optischen Polarisation) trennen. Da die Lagen L₁, L₂ im Allgemeinen beliebig gewählt und im Speziellen nach Eingabe der Parameter in die Einrichtung 62 zur Einschreibung festgelegt werden können, besteht die Steuermöglichkeit, die Domänenwande 2, 3, 4, 33 über eine Steuereinrichtung 10 (in Fig. 3)
- gesteuert zu schreiben,
- gesteuert zu löschen und
- gesteuert zu verschieben.

Eine Domänenwand 2, 3, 4, 33 induziert über elektrische, optische oder andere Strukturierungsmöglichkeiten und stellt eine Diskontinuität in Form der folgend beschriebenen Möglichkeiten dar:
- als eine nanoskalige Kontaktierungsschicht (in Fig. 4), wobei es möglich ist, mit Hilfe der Domänenwände 2, 3, 4 sowohl mit Ionen als auch mit Elektronen/Lochtransport nanoskalige Bauteile zu kontaktieren und so Ströme zu leiten, womit eine Integration und Adressierung solcher Bausteine auf der Ein-Nanometer-Längenskala möglich ist,
- als eine Schicht (in Fig. 5) für eine Modulation der dielektrischen Konstanten ε, wobei, falls die Domänenwand 33 leitfähig wird, sich ihre dielektrischen, resistiven und optischen Eigenschaften ändern, womit ein Einkristall 32, der dem Einkristall 40 gleichen kann, vom Isolator zum Leiter geschaltet werden und somit eine Modulation und Variation der Parameter auf der Ein-Nanometer-Längenskala eingestellt werden kann.

Zum Letzteren ist in Fig. 5 der isolierende ferroelektrische/ferroische Einkristall 32 mit einer lateralen Domänenwand 33 gezeigt, bei der eine optische Funktionalität durch eine räumliche Modulation der Dielektrizitätskonstanten ε erreicht wird, wobei
einerseits in die Domänenwand 33 eine Lichtwelle 35 über die Frontseite 34 in den Eingang 14 eingekoppelt werden und die Domänenwand 33 als Wellenleiter dienen kann, und
andererseits eine seitliche Einkopplung einer Lichtwelle 36 über eine Seitenfläche 37 für eine abgeschwächte Totalreflexion an der elektrisch leitfähigen Domänenwand 33 durchgeführt werden kann.

Des Weiteren kann das Element 1 mit dem Einkristall 40 und den Domänenwänden 2, 3, 4 dargestellt werden:
- als eine Schicht mit einer Templatfunktion, wobei es möglich ist, organische, anorganische und/oder biologische Moleküle, Atome und/oder Salze an die Kontaktstellen zu adsorbieren, wobei aufgrund des hohen elektrischen Feldgradienten und der damit verbundenen Polarisation bzw. Polarisierbarkeit sich gezielt Strukturen adsorbieren und absorbieren lassen und wobei das Templat die Funktion erfüllt, großflächig und mit einer Genauigkeit von 1nm oder von Bruchteilen eines Nanometers Strukturen aufzubauen.

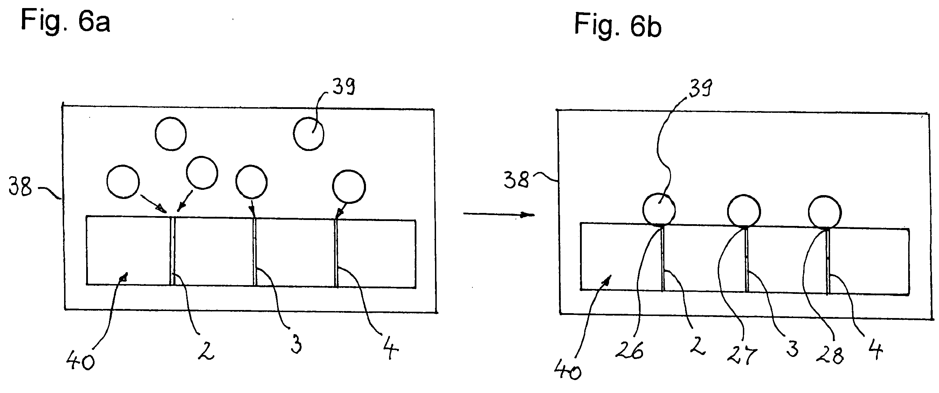

In den Fig. 6a und 6b ist jeweils als Einkristall 40 ein Templat zur gezielten, nasschemischen Adsorbatabscheidung angegeben, was in der Nanobiologie und Nanoelektronik eingesetzt werden kann. Die in einer flüssigen Adsorbatlösung 38 vorhandenen frei beweglichen gelösten Adsorbatpartikel 39 in Fig. 6a lagern sich nach kurzer Zeit unter UV-Beleuchtung mit Photonenenergien oberhalb der Bandlücke an die Nanokontaktpunkte 26, 27, 28 in Fig. 6b an und sind somit an die Domänenwände 2, 3, 4 gebunden. Durch die Variation der Beleuchtungsdauer und der Konzentration der Lösung mit Adsorbatpartikeln kann der Abscheideprozess gesteuert werden und so die Größe und Menge der angelagerten Partikel 39 eingestellt werden.

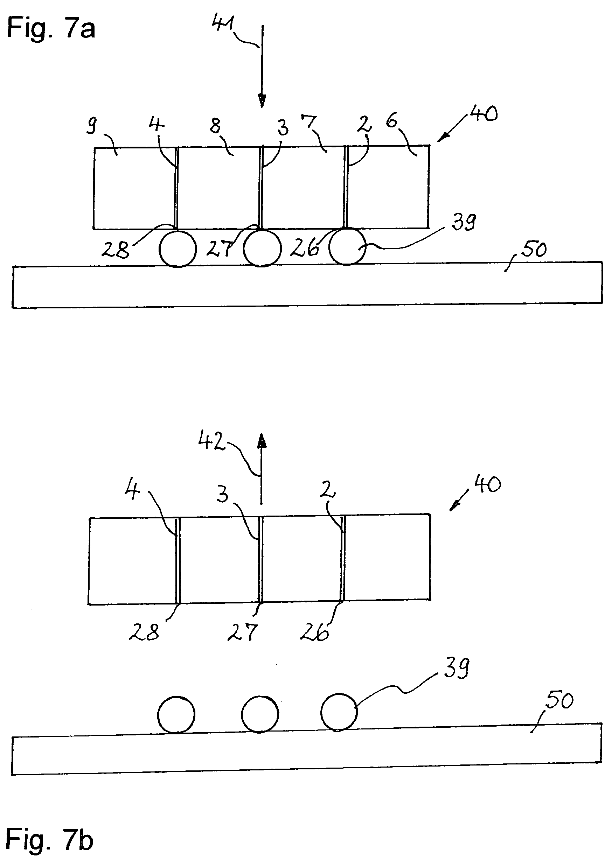

In den Fig. 7a und 7b, die auf den Fig. 6a und 6b basieren, wird der als Templat ausgebildete Einkristall 40 zu einem Substrat 50 transportiert, Durch Anpressen 41 in Fig. 7a werden die Adsorbatpartikel 39 auf das Substrat 50 aufgedruckt. Nach Lösen 42 des Einkristalls 40 vom Substrat 50 in Fig. 7b bleibt die von den Adsorbatpartikeln 39 übertragene Struktur als Druck an dem Substrat 50 haften.

### Bezugszeichenliste

- 1: Domänenstrukturiertes Element
- 2: Domänenwand
- 3: Domänenwand
- 4: Domänenwand
- 5: Steuereinheit
- 6: Domäne
- 7: Domäne
- 8: Domäne
- 9: Domäne
- 10: Steuereinrichtung
- 11: Kontaktspitzenelektrode
- 12: Elektrode
- 13: Positionierungs- und Halterungseinrichtung für Einkristall
- 14: Eingang einer Domänenwand
- 15: Kontaktelement
- 16: Kontaktelement
- 17: Kontaktelement
- 18: Verbindungsleitung zur Flächenelektrode
- 19: Verbindungsleitung
- 20: Verbindungsleitung
- 21: Speicher
- 22: Speicher
- 23: Steuer- und Rechenwerk
- 24: Seitenfläche
- 25: Seitenfläche
- 26: Nanokontaktpunkt
- 27: Nanokontaktpunkt
- 28: Nanokontaktpunkt
- 29: Makrokontaktpunkt
- 30: Makrokontaktpunkt
- 31: Makrokontaktpunkt
- 32: Einkristall
- 33: Domänenwand
- 34: Frontseite
- 35: Lichtwelle
- 36: Seitlich einfallende Lichtwelle
- 37: Seitenfläche
- 38: Adsorbatlösung
- 39: Adsorbatpartikel
- 40: Ferroelektrischer/ferroischer isolierender Einkristall
- 41: Anpressen
- 42: Lösen
- 43: Seitenfläche
- 44: Seitenfläche
- 45: Domänenwandstirnseite
- 46: Domänenwandstirnseite
- 47: Strommesseinrichtung
- 48: Lichtquelle
- 49: Spannungsquelle
- 50: Substrat
- 51: Magnet
- 52: Verbindungsleitung
- 53: Verbindungsleitung
- 54: Verbindungsleitung
- 55: Verbindungsleitung
- 56: Verbindungsleitung
- 57: Licht
- 58: Verbindungsleitung
- 59: Magnetisches Feld
- 60: Erste Vorrichtung
- 61: Zweite Vorrichtung
- 62: Einrichtung zur Einschreibung
- 63: Verbindungsleitung
- 64: Endteil der Rastersondenspitze
- 65: dritte Vorrichtung
- 66: Kondensator
- 67: Variable elektrische Feldstärke
- 68: Vierte Vorrichtung
- 69: Anordnung zur Übertragung mechanischer Zug/Druckspannungen Biegestation
- 70: Zug- oder Druckspannung
- 71: Kopf

- U: angelegte Spannung
- E: elektrische Feldstärke
- U_{koerzitiv}: Koerzitivspannung
- E_{koerzitiv}: elektrisches Koerzitivfeldstärke
- t: Zeitdauer
- ε: Dielektizitätskonstante

## Patentansprüche

1. Domänenstrukturiertes Element (1) mit mindestens einer Domänenwand (2) zwischen benachbarten Domänen (6, 7), verbunden zumindest mit einer Strommesseinrichtung (47) zur Messung von Strom in der zwischenliegenden Domänenwand (2),
wobei die Domänen (6, 7) und die zwischenliegende, zumindest nanoskalige Domänenwand (2) einem isolierenden ferroelektrischen/ferroischen Einkristall (40) zugeordnet sind,
wobei die Domänenwände (2, 3, 4; 33) des Einkristalls (40, 32) als jeweilige leitfähige Diskontinuität nur wenige Nanometer in der Breite messen und so geformt sind, dass sie nanoskopische, mikroskopische und/oder makroskopische Bereiche des Einkristalls (40; 32) verbinden, wobei die Domänenwände (2, 3, 4; 33)
- von einer oberen Seitenfläche (43, 24) zu einer unteren Seitenfläche (44, 25) in vertikaler Richtung (26-29, 27-30, 28-31) durch den Einkristall (40) hindurch oder
- von einem ersten Kontaktpunkt (14) zu einem zweiten Kontaktpunkt in lateraler Richtung des Einkristalls (32) oder
- in Kombination von Seitenflächen und Kontaktpunkten des vorgegebenen Einkristalls (40; 32)
verlaufen,
**dadurch gekennzeichnet,**
**dass** zur Erreichung und zur Ermittlung einer höheren elektrischen Leitfähigkeit in der zwischenliegenden Domänenwand (2, 3, 4) eine gesteuerte Einwirkung mittels einer elektrischen, magnetischen und/oder elektromagnetischen Anregungsenergie (67, 59, 57) und/oder einer mechanischen Zug- und Druckspannung (70) zumindest auf die zwischenliegende Domänenwand (2, 3, 4) des Einkristalls (40) vorgesehen ist, wobei die ermittelte elektrische Leitfähigkeit der zwischenliegenden Domänenwand (2) größer als die elektrische Leitfähigkeit der benachbarten Domänen (6, 7) ist, wobei die elektrische Leitfähigkeit der zwischenliegenden Domänenwand (2, 3, 4) in Form von elektrischem Strom mit unterschiedlich gepolten Elektroden (11, 12) mittels der mit den Elektroden (11, 12) verbundenen Strommesseinrichtung (47) zwischen den entgegengesetzten randseitigen Stirnbereichen (43, 44) der zwischenliegenden Domänenwand (2, 3, 4) messbar und steuerbar ist.

2. Element nach Anspruch 1,
**dadurch gekennzeichnet,**
**dass** die Steuerung der elektrischen Leitfähigkeit durch Beleuchtung (57) des Einkristalls (40) mit UV-Licht unterschiedlicher Intensitäten und Wellenlängen unterhalb der Bandlücke möglich ist, wobei durch Abschalten der Beleuchtung (57) die elektrische Leitfähigkeit in der Domänenwand (2, 3, 4) vollständig ausschaltbar ist.

3. Element nach Anspruch 1,
**dadurch gekennzeichnet,**
**dass** zur gesteuerten Einwirkung von elektrischer, magnetischer und/oder elektromagnetischer Anregungsenergie (67, 59, 57) und/oder mechanischer Zug- oder Druckspannung (70) auf die Domänenwand (2, 3, 4) dem Element (1) verschiedene Baugruppen zur Aussendung oder Übertragung von elektrischer, magnetischer und/oder elektromagnetischer Anregungsenergie (67, 59, 57) und/oder mechanischen Zug- und Druckspannungen (70) zugeordnet sind.

4. Element nach einem der Ansprüche 1 bis 3,
**dadurch gekennzeichnet,**
**dass** der Einkristall (40, 32) eine Dicke wahlweise von wenigen Nanometern bis in den Millimeter-Bereich aufweist.

5. Element nach den Ansprüchen 1 bis 4,
**dadurch gekennzeichnet,**
**dass** die Dicke der Domänenwände (2, 3, 4) zwischen den benachbarten Domänen (6, 7, 8, 9) im Ein-Nanometerbereich und in einem Bruchteil des Ein-Nanometerbereiches ausgebildet ist.

6. Element nach einem der Ansprüche 1 bis 5,
**dadurch gekennzeichnet,**
**dass** der Einkristall (40) als Templat zur gezielten nasschemischen Adsorbatabscheidung auf dem Einkristall (40) an der Domänenwand (2, 3, 4), wobei Spezies in Lösemittel an der Domänenwand (2, 3, 4) durch Reaktion mit bereitgestellten Ladungsträgern reduzieren oder oxidieren, vorgesehen ist.

7. Element nach einem der Ansprüche 1 bis 5,
**dadurch gekennzeichnet,**
**dass** der Einkristall (40) als Templat zur gezielten Gasphasen-Adsorbatabscheidung auf dem Einkristall (40) an der Domänenwand (2, 3, 4), wobei Spezies in Gasphase an der Domänenwand (2, 3, 4) durch Reaktion mit bereitgestellten Ladungsträgern reduzieren oder oxidieren, vorgesehen ist.

8. Element nach einem der Ansprüche 1 bis 5,
**dadurch gekennzeichnet,**
**dass** der Einkristall (32) mit der elektrisch leitfähigen Domänenwand (33) zur Wellenleiteranwendung eine veränderte Dielektrizitätskonstante in der Domänenwand (33) bei einer Stirnseiten-/seitlichen Einkopplung von einfallendem Licht (35) besitzt.

9. Verfahren zur Erzeugung und zur Steuerung der elektrischen Leitfähigkeit von Domänenwänden (2, 3, 4) in Elementen (1), das bei Raumtemperatur und an Luft durchgeführt wird, mit Elementen (1) nach den Ansprüchen 1 bis 5,
**dadurch gekennzeichnet,**
**dass** folgende Schritte durchgeführt werden
∘ Anbringen von Elektroden (11, 12) an sich gegenüberliegende Seitenflächen des Einkristalls (40),
∘ Erzeugung mindestens einer Domänenwand (2, 3, 4) im Einkristall (40) zwischen jeweils zwei entstehenden Domänenstrukturen (6, 7; 7, 8; 8, 9) zumindest mittels eines angelegten optischen oder elektrischen Feldes (58),
∘ gesteuerte Zuführung von elektrischer, magnetischer und/oder elektromagnetischer Anregungsenergie (67, 59, 57) und/oder mechanischen Zug- oder Druckspannungen (70) zumindest unter Einbeziehung der Domänenwand (2),
∘ Messung der durch das elektrische Feld (58) und der zugeführten elektrischen, magnetischen und/oder elektromagnetischen Anregungsenergie (67, 59, 57) und/oder von mechanischen Zug- oder Druckspannungen (70) ausgelösten und steuerbaren elektrischen Leitfähigkeit der Domänenwand (2).

10. Verfahren nach Anspruch 9,
**dadurch gekennzeichnet,**
**dass** die Domänenwände (2, 3, 4, 33) jeweils als eine Schicht nanoskaliger Kontaktierung erstellt werden, wobei mit Hilfe der Domänenwände (2, 3, 4; 33) sowohl mit Ionen- als auch mit Elektronen/Lochtransport der Einkristall (40; 32) kontaktiert und so Ströme geleitet werden, wodurch eine Integration und eine Adressierung des Einkristalls (40; 32) auf der Ein-Nanometer-Längenskala erreicht wird.

11. Verfahren nach Anspruch 10,
**dadurch gekennzeichnet,**
**dass** eine Löschung der Leitfähigkeit der Domänenwände (2, 3, 4) über das Löschen der gesamten Domänenstruktur (6, 7, 8, 9) durch komplettes Polen, wobei ein Einbringen in ein homogenes elektrisches Feld (58) E oberhalb einer vorgegebenen Koerzitivfeldstärke E_{koerzitiv} mit E > E_{koerzitiv} erfolgt, durchgeführt wird, wobei der Prozess mit einer Verschiebung der Domänenwände (2, 3, 4) zur Vergrößerung des in dem homogenen elektrischen Feld (58) ausgerichteten Domänenvolumenanteils geschieht und zur Veränderung der Domänenstruktur (6, 7) verwendet wird.

12. Verfahren nach einem der Ansprüche 9 bis 11,
**dadurch gekennzeichnet,**
**dass** zusätzlich zum Topografiebild im Kontaktmodus die lokale piezoelektrische Reaktion auf eine Wechselspannung an dem spitzwinkligen Endteil (64) der Rastersondenspitze (11) gemessen wird, aus der eine Domänenverteilung im Einkristall (40) und damit die Lage der leitfähigen Domänenwände (2, 3, 4) ermittelt werden.

13. Verfahren nach einem der Ansprüche 9 bis 12,
**dadurch gekennzeichnet,**
**dass** mindestens eine durch geometrische Parameter vorgegebene Domänenwand (2, 3, 4; 33) mittels einer Einrichtung (62) zur Einschreibung, die sich im Bereich des Einkristalls (40; 32) befindet, in den Einkristall (40; 32) solange eingeschrieben wird, bis eine nanoskalige Domänenwand (2, 3, 4; 33) erreicht wird, die von einer Seitenfläche (24) bis zur gegenüberliegenden Seitenfläche (25) des Einkristalls (40; 32) kristalldurchgängig ausgebildet wird, wobei die eingeschriebenen Domänenwände (2, 3, 4; 33) entsprechend vorgegebener zeitlicher und örtlicher Parameter wahlweise löschbar und/oder innerhalb des Einkristalls (40; 32) verschiebbar gesteuert werden.

14. Verfahren nach Anspruch 13,
**dadurch gekennzeichnet,**
**dass** die Lage (L₁, L₂) der Domänenwände (2, 3, 4, 33) vorgegeben und eine Steuerung festgelegt wird, um die eingebrachten Domänenwände (2, 3, 4, 33)
- gesteuert zu einzuschreiben,
- gesteuert zu löschen und
- gesteuert zu verschieben.

15. Verfahren nach einem der Ansprüche 9 bis 14,
**dadurch gekennzeichnet,**
**dass** die Domänenwände (2, 3, 4, 33) jeweils als eine Schicht mit einer Templatfunktion versehen werden, um organische, anorganische, biologische Moleküle, Atome, Salze an die Kontaktstellen zu adsorbieren, wobei sich dorthin aufgrund des hohen elektrischen Feldgradienten und der damit verbundenen Polarisation oder Polarisierbarkeit gezielt gesteuert Strukturen adsorbieren und absorbieren lassen, wobei das Templat die Funktion erfüllt, großflächig und mit einer Genauigkeit von einem Nanometer oder Bruchteilen von einem Nanometer Strukturen aufzubauen.

16. Verfahren nach einem der Ansprüche 9 bis 14,
**dadurch gekennzeichnet,**
**dass** die Domänenwände (2, 3, 4, 33) jeweils als eine Schicht mit einer Modulation der komplexen dielektrischen Konstanten (ε) erstellt und leitfähig ausgebildet werden, so dass sich ihre dielektrischen, resistiven und optischen Parameter ändern, wodurch der Einkristall (40) in den Domänenwänden (2, 3, 4) vom Isolator zum Leiter geschaltet wird und somit eine Modulation und Variation der Parameter auf der Ein-Nanometer-Längenskala eingestellt werden.

17. Verfahren nach einem der Ansprüche 9 bis 14,
**dadurch gekennzeichnet,**
**dass** einerseits in die Domänenwand (33) Licht (35) über die Frontseite (34) in einen Eingang (14) eingekoppelt wird und die Domänenwand (33) als Wellenleiter dient und/oder
andererseits eine seitliche Einkopplung des Lichts (36) über eine Seitenfläche (37) für eine abgeschwächte Totalreflexion an der elektrisch leitfähigen Domänenwand (33) durchgeführt wird.

18. Verfahren nach den Ansprüchen 9 bis 17,
**dadurch gekennzeichnet,**
**dass** in der Domänenwand (2) ein Ionentransport herbeigeführt wird, wobei Dotier-Ionen durch das angelegte elektrische Feld (58) aus der benachbarten Domänenstruktur (6, 7) gezogen werden, so dass Ionen von den Kontaktpunkten (26, 27, 28) oder von der Stirnfläche (45) der Domänenwand (2) passend nachgeschoben werden.

19. Vorrichtung (60) zur Steuerung der elektrischen Leitfähigkeit von Domänenwänden (2) in den Elementen (1) nach den Ansprüchen 1 bis 8,
**dadurch gekennzeichnet,**
**dass** zu ihr eine an das Element (1) über die Domänenwand (2) durch stirnseitig gegenüberliegend kontaktierende Elektroden (11, 12) angeschlossene Strommesseinrichtung (47) gehört, wobei die Vorrichtung (60) enthält
∘ eine Lichtquelle (48) zur Beleuchtung (57) zumindest der Domänenwand (2) und/oder
∘ eine Spannungsquelle (49) zur Erzeugung eines elektrischen Feldes (58) zwischen den beiden Elektroden (11, 12),
wobei wahlweise eine Beleuchtung (57) mit einstellbarer Wellenlänge und/oder einstellbarer Intensität des Lichtes und/oder eine variable Spannung zur Ausbildung einer variablen elektrischer Feldstärke (58) vorhanden sind, und
∘ eine Steuereinheit (5), die mit der Strommesseinrichtung (47) verbunden ist und die mit der Lichtquelle (48) und/oder mit der Spannungsquelle (49) in energieversorgungsleitungsmäßiger und signaltechnischer Verbindung steht.

20. Vorrichtung (61) zur Steuerung der elektrischen Leitfähigkeit von Domänenwänden (2) in den Elementen (1) nach den Ansprüchen 1 bis 8,
**dadurch gekennzeichnet,**
**dass** zu ihr eine an das Element (1) über die Domänenwand (2) durch stirnseitig gegenüberliegend kontaktierende Elektroden (11, 12) angeschlossene Strommesseinrichtung (47) gehört, wobei die Vorrichtung (61) neben der Steuereinheit (5), die mit der Strommesseinrichtung (47) verbunden ist, einen Magneten (51) mit konstanter Feldstärke oder dimensioniert variabler magnetischer Feldstärke (59) enthält, wobei das magnetische Feld die Domänenwand (2) durchdringt, wobei der Magnet (51) mit variabler Feldstärke (59) mit der Steuereinheit (5) in energieversorgungsleitungsmäßiger und signaltechnischer Verbindung steht.

21. Vorrichtung nach Anspruch 19 und 20,
**dadurch gekennzeichnet,**
**dass** der Magnet (51) in die Vorrichtung (60) mit Beleuchtung (57) und/oder variablem elektrischen Feld (58) integriert ist, wobei die vorgesehenen Verbindungsleitungen (52, 53, 54, 55, 56) zwischen den einzelnen Baugruppen (48, 49, 51, 47) weitgehend bestehen bleiben.

22. Vorrichtung (65) zur Steuerung der elektrischen Leitfähigkeit von Domänenwänden (2) in den Elementen (1) nach den Ansprüchen 1 bis 8,
**dadurch gekennzeichnet,**
**dass** zu ihr eine an das Element (1) über die Domänenwand (2) durch stirnseitig gegenüberliegend kontaktierende Elektroden (11, 12) angeschlossene Strommesseinrichtung (47) gehört, wobei die Vorrichtung (65) neben der Steuereinheit (5), die mit der Strommesseinrichtung (47) verbunden ist, einen Kondensator (66) mit konstanter Feldstärke oder dimensioniert variabler elektrischer Feldstärke (59) enthält, wobei das elektrische Feld die Domänenwand (2) durchdringt, wobei der Kondensator (66) mit variabler Feldstärke (59) mit der Steuereinheit (5) in energieversorgungs- und signaltechnischer Verbindung steht.

23. Vorrichtung nach den Ansprüchen 19 und 22,
**dadurch gekennzeichnet,**
**dass** der Kondensator (66) in die Vorrichtung (60) mit Beleuchtung (57) und/oder variablem elektrischen Feld (58) integriert ist, wobei die vorgesehenen Verbindungsleitungen (52, 53, 54, 55, 56) zwischen den einzelnen Baugruppen (48, 49, 51, 47) weitgehend bestehen bleiben.

24. Vorrichtung (68) zur Steuerung der elektrischen Leitfähigkeit von Domänenwänden (1) in den Elementen (1) nach den Ansprüchen 1 bis 8,
**dadurch gekennzeichnet,**
**dass** zu ihr eine an das Element (1) über die Domänenwand (2) durch stirnseitig gegenüberliegend kontaktierende Elektroden (11, 12) angeschlossene Strommesseinrichtung (47) gehört, wobei die Vorrichtung (68) neben der Steuereinheit (5), die mit der Strommesseinrichtung (47) verbunden ist, eine Anordnung zur Übertragung mechanischer Zug/Druckspannungen als Biegestation (69), welche Zug- oder Druckspannungen auf das domänenstrukturierte Element (1) und somit auf die Domänenwand (2) ausübt, wobei die Biegestation (69) mit der Steuereinheit (5) in energieversorgungsleitungsmäßiger und signaltechnischer Verbindung steht, wobei die Zug- oder Druckspannung (70) durch eine mechanische Verbiegung eines Substrates (50) oder durch einen piezomechanischen Aktor einstellbar ist.

25. Vorrichtung nach den Ansprüchen 19 und 24,
**dadurch gekennzeichnet,**
**dass** die Biegestation (69) in die Vorrichtung (60) mit Beleuchtung (57) und/oder variablem elektrischen Feld (58) und/oder mit dem variablen magnetischen Feld (59) integriert ist, wobei die vorgesehenen Verbindungsleitungen (52, 53, 54, 55, 56) zwischen den einzelnen Baugruppen (48, 49, 51, 47) weitgehend bestehen bleiben.

26. Einrichtung (62) zur Erzeugung und zur Steuerung von elektrisch leitfähigen Domänenwänden (2, 3, 4) in den Elementen (1) nach den Ansprüchen 1 bis 8,
**dadurch gekennzeichnet,**
**dass** sie unter Verwendung eines im Element (1) integrierten isolierenden ferroelektrischen/ferroischen Einkristalls (40) enthält
- zumindest eine Steuereinrichtung (10), die
- einen Speicher (21) für die geometrischen und die strukturzugehörigen Parameter des Einkristalls (40; 32) und
- einen Speicher (22) für die vorgegebenen geometrischen und strukturzugeordneten Parameter der einzuschreibenden Domänenwände (2, 3, 4; 33) aufweist, und
- zumindest ein Rechen- und Steuerwerk (23), mit dem die vorgegebenen Parameter berechnet und die Signale erzeugt werden, um die vorgegebenen Domänenwände (2, 3, 4; 33) in den Einkristall (40; 32) einzuschreiben und wahlweise die eingeschriebenen Domänenwände (2, 3, 4; 33) zu löschen oder innerhalb des Einkristalls (40; 32) in vorgegebene Lagen zu verschieben,
- mindestens einen Kopf mit mindestens zwei Elektroden (11, 12) mit den zugeordneten Kontakt/Abgriffselementen (15, 16, 17) zum Einschreiben, Löschen und Verschieben der nanoskaligen Domänenwände (2, 3, 4; 33),
- eine Positionierungs- und Halterungseinrichtung (13) für den Einkristall (40; 32) sowie
- zumindest zugehörige energieversorgungs- und signaltechnische Verbindungsleitungen (18, 19, 20, 63) zwischen der Steuereinrichtung (10) und zugeordneten Baugruppen (11, 13).

27. Verwendung von nanoskalige Domänenwände (2, 3, 4) enthaltenden Elementen (1) unter Einsatz des Verfahrens nach den Ansprüchen 16 und 17,
**dadurch gekennzeichnet,**
**dass** der Einkristall (32) mit mindestens einer Domänenwand (33) als Wellenleiter durch eine veränderte Dielektrizitätskonstante (ε) in der elektrisch leitfähigen Domänenwand (33) mit einer Stirnseiten-/seitlichen Einkopplung von Licht (35, 36) eingesetzt wird.

28. Verwendung von nanoskalige Domänenwände (2, 3, 4) enthaltenden Elementen (1) unter Einsatz des Verfahrens nach Anspruch 15,
**dadurch gekennzeichnet,**
**dass** als Einkristall (40) mit den nanoskaligen Domänenwänden (2, 3, 4) ein Templat zur gezielten, nasschemischen Adsorbatabscheidung von Adsorbatpartikeln (39) angewendet wird, wobei die in einer flüssigen Lösung (38) vorhandenen frei beweglichen gelösten Adsorbatpartikel (39) sich an die Nanokontaktpunkte (26, 27, 28) der Domänenwände (2, 3, 4) anlagern.

29. Verwendung von nanoskalige Domänenwände (2, 3, 4) enthaltenden Elementen (1) nach Anspruch 28,
**dadurch gekennzeichnet,**
**dass** der als Templat ausgebildete Einkristall (40) zu einem Substrat (50) transportiert wird und dort durch Anpressen (41) die Adsorbatpartikel (39) auf das Substrat (50) aufgedruckt werden, wobei nach Lösen (42) des Templats vom Substrat (50) weg gerichtet die von den Adsorbatpartikeln (39) übertragene Struktur als Druck an dem Substrat (50) haften bleibt.

## Claims

1. Domain structured element (1) with at least one domain wall (2) between adjacent domains (6, 7) connected to each other with at least one current measurement device (47) for measurement of the current in the intermediate domain wall (2),
wherein the domains (6, 7) and the at least nano-scale intermediate domain wall (2) are allocated to an isolating ferroelectric/ferroic mono-crystal (40), wherein the domain walls (2, 3, 4; 33) of the mono-crystal (40, 32) as respective conductive discontinuity are only several nanometres in width and shaped so that they connect nanoscopic, microscopic and/or macroscopic areas of the mono-crystal (40, 32), wherein the domain walls (2, 3, 4; 33) run
- from an upper lateral surface (43, 24) to a lower lateral surface (44, 25) in a vertical direction (26-29, 27-30, 28-31) through the mono-crystal (40), or
- from a first contact point (14) to a second contact point in a lateral direction of the mono-crystal (32), or
- in a combination of lateral surfaces and contact points of the given mono-crystal (40; 32),
**characterized in that**
a controlled action with an electric, magnetic and/or electromagnetic excitation energy (67, 59, 57) and/or a mechanical tensile and compressive load (70) acting at least on the intermediate domain wall (2, 3, 4) of the mono-crystal (40) is provided to achieve and determine a higher electrical conductivity of the intermediate domain wall (2, 3, 4) wherein the determined electrical conductivity of the intermediate domain wall (2) is larger than the electrical conductivity of the adjacent domains (6, 7), wherein the electrical conductivity of the intermediate domain wall (2, 3, 4) can be measured and controlled between the opposing front surfaces (43, 44) of the intermediate domain wall (2, 3, 4) with an electrical current from electrodes with different poles (11, 12) using the current measurement device (47) connected to the electrodes (11, 12).

2. Element according to Claim 1,
**characterized in that**
the control of the electrical conductivity is possible by exposing (57) the mono-crystal (40) to UV light of different intensities and wavelengths below the band gap, wherein the electrical conductivity in the domain wall (2, 3, 4) can be switched off completely by switching the light source (57) off.

3. Element according to Claim 1,
**characterized in that**
different assembly groups for the emission and transmission of electrical, magnetic and/or electromagnetic excitation energy (67, 59, 57) and/or mechanical tensile and compressive loads (70) are allocated to the element (1) for the controlled action of electrical, magnetic and/or electromagnetic excitation energy (67, 59, 57) and/or mechanical tensile or compressive load (70) acting on the domain wall (2, 3, 4).

4. Element according to one of the Claims 1 to 3,
**characterized in that**
the mono-crystal (40, 32) has a thickness selected from a range between several nanometres and the millimetre range.

5. Element according to Claims 1 to 4,
**characterized in that**
the thickness of the domain walls (2, 3, 4) between the adjacent domains (6, 7, 8, 9) is produced in the range of one nanometre and at a fraction of the one-nanometre range.

6. Element according to one of the Claim 1 to 5,
**characterized in that**
the mono-crystal (40) is provided as a template for the targeted wet-chemical adsorbate deposition on the mono-crystal (40) at the domain wall, (2, 3, 4) wherein species in solvents at the domain wall (2, 3, 4) reduce or oxidise through reaction with provided charge carriers.

7. Element according to one of the Claims 1 to 5,
**characterized in that**
the mono-crystal (40) is provided as a template for the targeted vapour adsorbate deposition on the mono-crystal (40) at the domain wall (2, 3, 4), wherein species in vapours at the domain wall (2, 3, 4) reduce or oxidise through reaction with provided charge carriers.

8. Element according to one of the Claims 1 to 5,
**characterized in that**
the mono-crystal (32) with the electrically conductive domain wall (33) for wave guide application has a changed dielectric constant in the domain wall (33) when the incoming light (35) is applied from the front/lateral surface.

9. Method for generation and controlling of electric conductivity of domain walls (2, 3, 4) in elements (1) performed at room temperature and in contact with air with elements (1) according to the Claims 1 to 5,
**characterized in that**
the following steps are performed
∘ Attachment of Electrodes (11, 12) to opposing lateral surfaces of the mono-crystal (40),
∘ Generation of at least one domain wall (2, 3, 4) in the mono-crystal (40) between two originating domain structures (6, 7; 7, 8; 8, 9), respectively, at least with one applied optical or electrical field (58),
∘ Controlled application of electric, magnetic and/or electromagnetic excitation energy (67, 59, 57) and/or mechanical tensile or compressive load (70) to at least the domain wall (2),
∘ Measurement of the controllable electric conductivity of the domain wall (2) produced by the electric field (58) and the applied electric, magnetic and/or electromagnetic excitation energy (67, 59, 57) and/or by mechanical tensile or compressive stress (70).

10. Method according to Claim 9,
**characterized in that**
the domain walls (2, 3, 4, 33) are each produced as a layer of a nanostructured contact, wherein the mono-crystal (40, 32) makes contact with ion as well as electron/hole transport with the help of the domain walls (2, 3, 4; 33) resulting in conduction of currents so that an integration and addressing of the mono-crystal (40; 32) is achieved in the one-nanometre length scale.

11. Method according to Claim 10,
**characterized in that**
the conductivity of the domain walls (2, 3, 4) is cancelled by cancelling the entire domain structure (6, 7, 8, 9) through complete poling, wherein it is inserted into an electric field (58) E above a specified coercive field strength E_{coercive} with E > E_{coercive}, wherein the process is realised with a shift of the domain walls (2, 3, 4) to enlarge the domain volume percentage maligned in the homogenous electric field (58) and is used to change the domain structure (6, 7).

12. Method according to one of the Claims 9 to 11,
**characterized in that**
, in addition to the topography image in contact mode, the local piezoelectric reaction to an alternating current is measured at the acute-angled end part (64) of the scanning probe (11), from which a domain distribution in the mono-crystal (40) and therefore the position of the conductive domain walls (2, 3, 4) is determined.

13. Method according to one of the Claims 9 to 12,
**characterized in that**
at least one domain wall (2, 3, 4; 33) specified by geometric parameters is registered with an apparatus (62) for registration located in the area of the mono-crystal (40; 32) until a nano-scale domain wall (2, 3, 4; 33) is reached that extends through the mono-crystal (40; 32) from one lateral surface (24) to the opposite lateral surface (25) of the mono-crystal (40; 32), while the registered domain walls (2, 3, 4; 33) are controlled according to temporal and local parameters with a possible cancellation and/or with the possibility to shift them within the mono-crystal (40; 32).

14. Method according to Claims 13,
**characterized in that**
the location (L₁, L₂) of the domain walls (2, 3, 4; 33) is given and a control is specified to
- register the domain walls (2, 3, 4; 33) in a controlled manner,
- cancel the domain walls (2, 3, 4; 33) in a controlled manner, and
- shift the domain walls (2, 3, 4; 33) in a controlled manner.

15. Method according to one of the Claims 9 to 14,
**characterized in that**
the domain walls (2, 3, 4; 33) are each provided as a layer with a template function in order to adsorb organic, anorganic, biological molecules, atoms, salts to the contact surface, whereby structures can be adsorbed in a targeted controlled way to this location due to the high electric field gradient and the associated polarisation or polarisability, while the template has the function to form structures with large areas and with an accuracy of one nanometre or fractions of a nanometre.

16. Method according to one of the Claims 9 to 14,
**characterized in that**
the domain walls (2, 3, 4; 33) are each created as a layer with a modulation of the complex dielectric constants (ε) and are produced with conductivity so that their dielectric, resistive and optical parameters change so that the mono-crystal (40) is switched from the isolator to the conductor in the domain walls (2, 3, 4) and therefore, a modulation and variation of the parameters is set on the one-nanometre length scale.

17. Method according to one of the Claims 9 to 14,
**characterized in that**
, on one hand, light (35) is applied into an entrance (14) of the domain wall (33) via the front surface (34) and the domain wall (33) is used as wave guide and/or
on the other hand, light (36) is applied laterally via the lateral surface (37) for a reduced total reflection at the electrically conductive domain wall (33).

18. Method according to Claims 9 to 17,
**characterized in that**
an ion transport is induced in the domain wall (2), while the dopants are removed from the adjacent domain structure (6, 7) by the applied electric field (58) so that compatible ions are pushed in from the contact points (26, 27, 28) or from the front surface (45) of the domain wall (2).

19. Apparatus (60) to control the electric conductivity of domain walls (2) in the elements (1) according to Claims 1 to 8,
**characterized in that**
it has a current measurement device (47), which is connected to the element (1) via opposing electrodes (11, 12) at the front surfaces making contact with the domain wall (2) wherein the apparatus (60) contains
∘ a light source (48) for the illumination of (57) at least the domain wall (2) and/or
∘ a voltage source (49) for the generation of an electric field (58) between the two electrodes (11, 12),
wherein either a light source (57) with adjustable wavelength and/or adjustable light intensity and/or a variable voltage to create a variable electrical field strength (58) is available, and
∘ a control unit (5), which is connected to the current measurement device (47) and which, in terms of energy supply line and signaling, is connected with the light source (48) or the voltage source (49).

20. Apparatus (61) for controlling the electric conductivity of domain walls (2) in the elements (1) according to Claims 1 to 8,
**characterized in that**
it has a current measurement device (47) connected to the element (1) via the domain wall (2) contacting with opposing electrodes (11, 12) at the front surfaces, wherein the apparatus (61) has a magnet (51) with constant field strength or dimensioned variable magnetic field strength (59) in addition to the control unit (5) connected to the current measurement device (47) with the magnetic field penetrating the domain wall (2), wherein the magnet (51) with variable field strength (59) is connected to the control unit (5) for energy supply and signallng.

21. Apparatus according to Claim 19 or 20,
**characterized in that**
the magnet (51) is integrated in the apparatus (60) with the light source (57) and/or the variable electric field (58), wherein the provided connection lines (52, 53, 54, 55, 56) remain as far as possible between the individual assembly groups (48, 49, 51, 47).

22. Apparatus (65) to control the electric conductivity of domain walls (2) in the elements (1) according to Claims 1 to 8,
**characterized in that**
it has a current measurement device (47) connected to the element (1) via the domain wall (2) contacting with opposing electrodes (11, 12) at the front surfaces, wherein the apparatus (65) has a capacitor (66) with constant field strength or dimensioned variable electric field strength (59) in addition to the control unit (5) connected to the current measurement device (47) with the electric field penetrating the domain wall (2), wherein the capacitor (66) with variable field strength (59) is connected to the control unit (5) in terms of energy supply and signalling.

23. Apparatus according to Claims 19 and 22,
**characterized in that**
the capacitor (66) is integrated in the apparatus (60) with the light source (57) and/or integrated in the variable electric field (58), wherein the provided connection lines (52, 53, 54, 55, 56) remain as far as possible between the individual assembly groups (48, 49, 51, 47).

24. Apparatus (68) for controlling the electric conductivity of domain walls (1) in the elements (1) according to Claims 1 to 8,
**characterized in that**
it has a current measurement device (47) connected to the element (1) via the domain wall (2) contacting with opposing electrodes (11, 12) at the front surfaces, wherein, in addition to the control unit (5) connected to the current measurement device (47), the apparatus (68) has a device to transmit mechanical tensile/compressive loads as bending station (69) applying tensile or compressive loads to the domain structured element (1) and therefore to the domain wall (2), while the bending station (69) is connected with the control unit (5) for energy supply and signalling, whereby it is possible to adjust the tensile or compressive load (70) with mechanical bending of a substrate (50) or through a piezomechanical actuator.

25. Apparatus according to Claims 19 and 24,
**characterized in that**
the bending station (69) is integrated in the apparatus (60) with the light source (57) and/or the variable electric field (58) and/or the variable magnetic field (59), while the provided connection lines (52, 53, 54, 55, 56) remain as far as possible between the individual assembly groups (48, 49, 51,47).

26. Apparatus (62) for generating and controlling electrically conductive domain walls (2, 3,4) in the elements (1) according to Claims 1 to 8,
**characterized in that**
, using a ferroelectrical/ferroic isolating mono-crystal (40) integrated in the element (1), it contains
- at least a control unit (10), which
- has a memory (21) for the geometric and structure-related parameters of the mono-crystal (40; 32) and
- a memory (22) for the specified geometric and structure-related parameters of the domain walls to be registered (2, 3, 4; 33), and
- at least one computer and control unit (23), with which the specified parameters are calculated and the signals are generated in order to register the specified domain walls (2, 3, 4; 33) in the mono-crystal (40; 32) and to either cancel the registered domain walls (2, 3, 4; 33) or to shift them into specified positions within the mono-crystal (40; 32),
- at least one head with at least two electrodes (11, 12) with the corresponding contact/tapping elements (15, 16, 17) for registering, cancelling and shifting of nano-scale domain walls (2, 3, 4; 33),
- a positioning and holding device (13) for the mono-crystal (40; 32) as well as
- at least one corresponding connection line (18, 19, 20,63) related to energy supply and signalling between the control unit (10) and associated assembly groups (11, 13).

27. Use of elements (1) containing nano-scale domain walls (2, 3, 4) using the method according to Claims 16 and 17,
**characterized in that**
the mono-crystal (32) is used with at least one domain wall (33) as waveguide through a changed dielectric constant (ε) in the electrically conductive domain wall (33) with light (35, 36) applied from the front/lateral side.

28. Use of efements (1) containing nano-scale domain walls (2, 3, 4) using the method according to Claim 15,
**characterized in that**
a template for targeted, wet-chemical adsorbate deposition of adsorbate particles (39) is used as mono-crystal (40) with the nano-scale domain walls (2, 3, 4), wherein the freely moveable, dissolved adsorbate particles (39) present in a liquid solution (38) attach to the nano-contact points (26, 27, 28) of the domain walls (2, 3, 4).

29. Use of elements (1) containing nano-scale domain walls (2, 3, 4) according to Claim 28,
**characterized in that**
the mono-crystal (40) formed as template is transported to a substrate (50) and that there the adsorbate particles (39) are applied onto the substrate (50) by pressing (41), wherein the structure transferred by the adsorbate particles (39) remains attached as an imprint on the substrate (50) after loosening (42) of the template away from the substrate (50).

## Revendications

1. Elément (1) structuré en domaines avec au moins une paroi de domaine (2) entre deux domaines environnants (6, 7), relié au moins à un dispositif de mesure de courant (47) pour mesurer le courant dans la paroi de domaine (2) interposée,
les domaines (6, 7) et au moins la paroi de domaine nanométrique (2) interposée étant associés à un monocristal ferroélectrique/ferroïque isolant (40), les parois de domaine (2, 3, 4, 33) du monocristal (40, 32), comme discontinuité conductrice ne mesurant que quelques nanomètres en largeur reliant des plages nanoscopiques, microscopiques et/ou macroscopique du monocristal (40, 32),
les parois de domaine (2, 3, 4, 33) passant
- d'une surface latérale supérieure (43, 24) vers une surface latérale inférieure (44, 25) dans la direction verticale (26-29, 27-30, 28-31) à travers le monocristal (40) ou
- d'un premier point de contact (14) vers un deuxième point de contact dans la direction latérale du monocristal (32) ou
- en combinaison des surfaces latérales et des points de contact du monocristal (40, 32) prédéfinis,
**caractérisé en ce que**
pour avoir et déterminer une conductibilité électrique plus élevée dans la paroi de domaine interposée (2, 3, 4), on exerce une action commandée avec une énergie d'excitation électrique, magnétique et/ou électromagnétique (67, 59, 57) et/ou avec une contrainte mécanique de traction et de compression (70), au moins sur la paroi de domaine (2, 3, 4, 33) interposée du monocristal (40), la conductibilité électrique obtenue de la paroi de domaine (2) interposée étant supérieure à celle des domaines environnants (6, 7), la conductibilité électrique de la paroi de domaine interposée (2, 3, 4) se mesurant et se commandant sous forme de courant électrique avec des électrodes (11, 12) à différentes polarités à l'aide du dispositif de mesure de courant (47) associé aux électrodes (11, 12) entre les zones frontales marginales opposées (43, 44) de la paroi de domaine (2, 3, 4) interposée.

2. Elément selon la revendication 1,
**caractérisé en ce qu'**
on peut commander la conductibilité électrique par l'éclairage (57) du monocristal (40) à la lumière UV d'intensité et de longueur d'onde différentes en dessous de la bande interdite, la coupure de l'éclairage (57) arrêtant complètement la conductibilité électrique dans la paroi de domaine (2, 3, 4).

3. Elément selon la revendication 1,
**caractérisé en ce que**
différents organes pour émettre ou transmettre l'énergie d'excitation électrique, magnétique et/ou électromagnétique (67, 59, 57) et/ou la contrainte mécanique en traction et en compression (70) sont associés à l'élément (1) pour commander l'énergie d'excitation électrique, magnétique et/ou électromagnétique (67, 59, 57) et/ou la contrainte mécanique de traction et de compression (70) sur la paroi de domaine (2, 3, 4).

4. Elément selon l'une des revendications 1 à 3,
**caractérisé en ce que**
le monocristal (40, 32) a une épaisseur choisie entre quelques nanometres jusqu'à la plage des millimètres.

5. Elément selon les revendications 1 à 4,
**caractérisé en ce que**
l'épaisseur des parois de domaine (2, 3, 4) entre les domaines environnants (6, 7, 8, 9) est dans la plage de un nanomètre et dans celle d'une fraction de la plage de un nanomètre.

6. Elément selon l'une des revendications 1 à 5,
**caractérisé en ce que**
le monocristal (40) est la matrice pour la séparation ciblée d'absorbat chimique humide sur le monocristal (40) à la paroi de domaine (2, 3, 4), des espèces dans le solvant à la paroi de domaine (2, 3, 4) sont réduites ou oxydées par les porteurs de charge obtenus par réaction.

7. Elément selon l'une des revendications 1 à 5,
**caractérisé en ce que**
le monocristat (40) est la matrice pour ta séparation ciblée d'absorbat en phase gazeuse sur le monocristal (40) à la paroi de domaine (2, 3, 4), des espèces dans la phase gazeuse à la paroi de domaine (2, 3, 4) étant réduites ou oxydées par les porteurs de charge obtenus par réaction.

8. Elément selon l'une des revendications 1 à 5,
**caractérisé en ce que**
pour son application comme guide d'ondes, le monocristal (32) avec la paroi de domaine électroconductrice (33) possède une constante diélectrique modifiée dans la paroi de domaine (33) par couplage de lumière incidente (35) côté frontal/latéral.

9. Procédé de génération et de commande de la conductibilité électrique de parois de domaine (2, 3, 4) dans des éléments (1), effectué à température ambiance et à l'air, avec des éléments (1) selon les revendications 1 à 5, **caractérisé en ce que**,
on effectue les étapes suivantes :
∘ application d'électrodes (11, 12) aux surfaces latérales opposées du monocristal (40),
∘ génération d'au moins une paroi de domaine (2, 3, 4) dans le monocristal (40) entre respectivement deux structures de domaine (6, 7; 7, 8; 8, 9) en appliquant au moins un champ (58) optique ou électrique,
∘ application commandée d'énergie d'excitation électrique, magnétique et/ou électromagnétique (67, 59, 57) et/ou de contraintes mécaniques de traction et de compression (70) au moins en intégrant la paroi de domaine (2),
∘ mesure de la conductibilité électrique de la paroi de domaine (2) déclenchée et commandée par le champ électrique (58) et l'énergie d'excitation électrique, magnétique et/ou électromagnétique (67, 59, 57) appliquée et/ou par des contraintes mécaniques de traction et de compression (70).

10. Procédé selon la revendication 9,
**caractérisé en ce que**
les parois de domaine (2, 3, 4, 33) sont réalisées respectivement comme couche de contact nanométrique, le monocristal (40, 32) étant en contact tant par transport d'ions qu'avec des électrons/trous avec les parois de domaine (2, 3, 4, 33) transmettant ainsi des courants permettant l'intégration et l'adressage du monocristal (40, 32) sur une échelle de longueur de un nanomètre.

11. Procédé selon la revendication 10,
**caractérisé en ce que**
on supprime la conductibilité des parois de domaine (2, 3, 4) par la suppression de l'ensemble de la structure de domaine (6, 7, 8, 9) par polarisation complète, par introduction dans un champ électrique homogène (58) E supérieur à une intensité donnée E_{coercitif} de champ coercitif avec E > E_{coercitif}, le procédé étant effectué avec un déplacement des parois de domaine (2, 3, 4) pour agrandir la part de volume de domaine orientée dans le champ électrique homogène (58) et pour modifier la structure de domaine (6, 7).

12. Procédé selon l'une des revendications 9 à 11,
**caractérisé en ce que**
en plus de l'image topographique en mode contact, on mesure la réaction locale piézoélectrique à une tension alternative à la partie d'extrémité pointue (64) de la pointe (11) de la sonde de balayage et à partir de la on détermine une répartition de domaine dans le monocristal (40) et ainsi la position des parois de domaine (2, 3, 4) conductrices.

13. Procédé selon l'une des revendications 9 à 12,
**caractérisé en ce qu'**
un dispositif (62) d'inscription dans la zone du monocristal (40, 32) inscrit au moins une paroi de domaine (2, 3, 4, 33) définie par des paramètres géométriques dans le monocristal (40, 32) jusqu'à atteindre une paroi de domaine (2, 3, 4, 33) nanométrique qui traverse le monocristal (40, 32), d'une surface latérale (24) jusqu'à la surface latérale opposée (25), les parois de domaine (2, 3, 4, 33) inscrites sélectionnées étant commandées, pour être effacées et/ou déplacées dans le monocristal (40, 32) selon des paramètres de temps et de lieu donnés.

14. Procédé selon la revendication 13,
**caractérisé en ce que**
la position (L₁, L₂) des parois de domaine (2, 3, 4, 33) est donnée et une commande est établie pour
- inscrire,
- supprimer et
- déplacer
de façon commandée les parois de domaine introduites (2, 3, 4, 33).

15. Procédé selon l'une des revendications 9 à 14,
**caractérisé en ce que**
les parois de domaine (2, 3, 4, 33) respectives en tant que couches ont une fonction de matrice pour adsorber des molécules organiques, anorganiques, biologiques, des atomes, et des sels, aux points de contacts, ou des structures sont adsorbées et adsorbées de manière ciblée, commandée sous l'effet du gradient de champ électrique élevé et de la polarisation ou la possibilité de polarisation inhérente, la matrice assumant la fonction de réaliser des structures sur une grande surface et avec la précision d'un nanomètre ou de fraction de nanomètre.

16. Procédure selon l'une des revendications 9 à 14,
**caractérisé en ce que**
les parois de domaine (2, 3, 4, 33) sont réalisées conductrices comme une couche avec une modulation des constantes diélectriques complexes (ε) de façon que leurs paramètres diélectriques, résistifs et optiques se modifient, commutant le monocristal (40) dans les parois de domaine (2, 3, 4), de l'état d'isolant à l'état conducteur en réglant ainsi une modulation et une variation des paramètres à l'échelle de longueur de un nanomètre.

17. Procédure selon l'une des revendications 9 à 14,
**caractérisée en ce que**
d'une part on injecte, de la lumière (35) dans la paroi de domaine (33), par le côté frontal (34) dans une entrée (14), la paroi de domaine (33) servant de guide d'ondes et/ou
d'autre part, on injecte latéralement de la lumière (36) par une surface latérale (37) pour une réflexion totale atténuée sur la paroi de domaine (33) électroconductrice.

18. Procédure selon les revendications 9 à 17,
**caractérisée en ce que**
dans la paroi de domaine (2), on génère un transport d'ions, des ions de dopage étant extraits de la structure de domaine environnante (6, 7) par le champ électrique (58) appliqué de façon que les ions soient poussés de façon adaptée par les points de contact (26, 27, 28) ou par la surface frontale (45) de la paroi de domaine (2).

19. Dispositif (60) de commande de la conductibilité électrique de parois de domaine (2) dans les éléments (1) selon les revendications 1 à 8
**caractérisé en ce que**
il a un dispositif de mesure de courant (47) sur la paroi de domaine (2) raccordé à l'élément (1) par des électrodes (11, 12) en contact sur les côtés opposés frontalement, le dispositif (60) ayant
∘ une source de lumière (48) pour éclairer (57) au moins la paroi de domaine (2) et/ou
∘ une source de tension (49) pour générer un champ électrique (58) entre les deux électrodes (11, 12),
et sélectivement on a un éclairage (57) à longueur d'onde réglable et/ou à intensité de lumière réglable et/ou une tension variable pour développer une intensité électrique (58) de champ et
∘ une unité de commande (5) raccordée au dispositif de mesure de courant (47) et reliée à la source de lumière (48) et/ou à la source de tension (49) par une liaison d'alimentation en énergie ou de transmission de signaux.

20. Dispositif (61) de commande de la conductibilité électrique de parois de domaine (2) dans les éléments (1) selon les revendications 1 à 8
**caractérisé en ce que**
il a un dispositif de mesure de courant (47) sur la paroi de domaine (2) raccordé à l'élément (1) par des électrodes (11, 12) en contact sur des côtés opposés frontalement, le dispositif (61), outre l'unité de commande (5) raccordée au dispositif de mesure de courant (47), ayant un aimant (51) à intensité de champ constante ou à intensité magnétique (59) à dimensionnement variable, le champ magnétique traversant la paroi de domaine (2), l'aimant (51) à intensité de champ variable (59) étant relié à l'unité de commande (5) par une liaison d'alimentation en énergie ou de transmission de signaux.

21. Dispositif selon les revendications 19 et 20,
**caractérisé en ce que**
l'aimant (51) est intégré dans le dispositif (60) avec éclairage (57) et/ou avec champ électrique variable (58), les câbles de connexion (52, 53, 54, 55, 56) restant maintenus en grande partie entre les différents composants (48, 49, 51, 47).

22. Dispositif (65) de commande de la conductibilité électrique de parois de domaine (2) dans les éléments (1) selon les revendications 1 à 8
**caractérisé en ce que**
il possède un dispositif de mesure de courant (47) sur la paroi de domaine (2) raccordé à l'élément (1) par des électrodes (11, 12) en contact sur des côtés opposés frontalement, le dispositif (65), outre l'unité de commande (5) raccordée au dispositif de mesure de courant (47), ayant un condensateur (66) à intensité de champ constante ou à intensité de champ électrique variable (59), le champ électrique traversant la paroi de domaine (2), le condensateur (66) à intensité de champ variable (59) étant en connexion avec l'unité de commande (5) par une liaison d'alimentation en énergie et de transmission de signaux.

23. Dispositif selon les revendications 19 et 22
**caractérisé en ce que**
le condensateur (66) est intégré dans le dispositif (60) avec éclairage (57) et/ou champ électrique variable (58), les câbles de connexion (52, 53, 54, 55, 56) restant maintenus en grande partie entre les différents composants (48, 49, 51, 47).

24. Dispositif (68) de commande de la conductibilité électrique de parois de domaine (2) dans les éléments (1) selon les revendications 1 à 8
**caractérisé en ce que**
il possède un dispositif de mesure de courant (47) sur la paroi de domaine (2) raccordé à l'élément (1) via des électrodes (11, 12) en contact sur des côtés opposés frontalement, le dispositif (68) outre l'unité de commande (5) raccordée au dispositif de mesure de courant (47) ayant un dispositif de transmission de contraintes mécaniques en traction et en compression en tant que station de flexion (69) qui exerce des contraintes de traction et de compression sur l'élément à structure de domaine (1) et donc sur la paroi de domaine (2), la station de flexion (69) étant reliée à l'unité de commande (5) par une liaison d'alimentation en énergie ou de transmission de signaux, la contrainte de traction ou de compression (70) étant réglée par une déformation mécanique d'un substrat (50) ou par un actionneur piézomécanique.

25. Dispositif selon les revendications 19 et 24
**caractérisé en ce que**
la station de flexion (69) est intégrée dans le dispositif (60) avec éclairage (57) et/ou champ électrique variable (58) et/ou avec le champ magnétique variable (59), les câbles de connexion (52, 53, 54, 55, 56) restant maintenus en grande partie entre les différents composants (48, 49, 51, 47).

26. Installation (62) de génération et de commande de paroi de domaine (2, 3, 4) à conductibilité électrique dans les éléments (1) selon les revendications 1 à 8
**caractérisée en ce qu'**
en utilisant un monocristal (40) ferroélectrique/ferroïque isolant, intégré dans l'élément (1) elle a
- au moins une dispositif de commande (10) ayant
- une mémoire (21) pour les paramètres géométriques et de structure du monocristal (40, 32)
- une mémoire (22) pour les paramètres géométriques donnés et de structure des parois de domaine (2, 3, 4, 33) à inscrire et
- au moins un ordinateur et une unité de commande (23) pour calculer les paramètres donnés et générer les signaux pour inscrire les parois de domaine (2, 3, 4, 33) prédéfinis dans le monocristal (40, 32) et, supprimer sélectivement les parois de domaine (2, 3, 4, 33) inscrites ou les déplacer dans des positons prédéfinies dans le monocristal (40, 32),
- au moins une tête avec au moins deux électrodes (11, 12) et les éléments de contact/prise (15, 16, 17) pour inscrire, supprimer et déplacer les parois de domaine (2, 3, 4, 33) nanométriques,
- un dispositif de positionnement et de maintien (13) du monocristal (40, 32) ainsi que
- au moins des liaisons (18, 19, 20, 63) d'alimentation en énergie ou de transmission de signaux entre l'unité de commande (10) et les composants associés (11, 13).

27. Utilisation d'éléments (1) ayant des parois de domaine nanométriques (2, 3, 4) appliquant le procédé selon les revendications 16 et 17
**caractérisée en ce que**
on utilise comme guide d'ondes le monocristal (32) ayant au moins une paroi de domaine (33) en modifiant la constante de diélectrique (ε) dans la paroi de domaine (33) électroconductrice par une injection frontale/latérale de lumière (35, 36).

28. Utilisation d'éléments (1) ayant des parois de domaine, nanométriques, (2, 3, 4) appliquant le procédé selon la revendication 15
**caractérisée en ce que**
comme monocristal (40) avec les parois de domaine (2, 3, 4) nanométriques, on utilise une matrice pour la séparation ciblée, en chimie humide de particules d'absorbat (39), les particules d'absorbat (39) dissoutes, librement mobiles dans la solution liquide (38) se déposant aux points de contact nanométriques (26, 27, 28) des parois de domaine (2, 3, 4).

29. Utilisation d'éléments (1) ayant des parois de domaine (2, 3, 4) nanométriques selon la revendication 28
**caractérisée en ce que**
on transporte le monocristal (40) formé comme matrice vers un substrat (50) et on y presse les particules d'absorbat (39) sur le substrat (50) par pression (41), et après avoir enlevé (42) la matrice du substrat (50), la structure transmise par les particules d'absorbat (39) reste sur le substrat (50) comme empreinte.
